# EUROPEAN PATENT APPLICATION

(11) **EP 4 395 475 A1**
(43) Date of publication of application: **03.07.2024**
(21) Application number: 22861762.7
(22) Date of filing: 26.08.2022
(51) Int. Cl.: H05K 1/11, H05K 3/40, H05K 3/28, H05K 3/46, H01L 23/498, H01L 23/538, H01L 23/31

(54) **CIRCUIT BOARD AND SEMICONDUCTOR PACKAGE COMPRISING SAME**

(30) Priority: 26.08.2021 KR 20210113329
(71) Applicant: LG INNOTEK CO., LTD., Seoul 07796 (KR)
(72) Inventor: NAM, Il Sik, Seoul 07796 (KR)
(74) Representative: M. Zardi & Co S.A.
(86) International application number: PCT/KR2022/012827
(87) International publication number: WO 2023/027554

(57) **Abstract**

A circuit board according to an embodiment includes an insulating layer; a first circuit pattern disposed on the insulating layer; a first protective layer disposed on the insulating layer and including an opening that vertically overlaps an upper surface of the first circuit pattern; a first connection part disposed in the opening; and an electrode part disposed on the first connection part, and wherein a width of an upper surface of the electrode part is smaller than a width of the opening of the first protective layer.

## Description

### [Technical Field]

The embodiment relates to a circuit board, and in particular, to a circuit board capable of improving adhesion between a pad and a post bump and a semiconductor package including the same.

### [Background Art]

As miniaturization, weight reduction, and integration of an electronic component are accelerated, a line width of a circuit has been miniaturized. In particular, as a design rule of a semiconductor chip is integrated on a nanometer scale, a circuit line width of a package substrate or a printed circuit board on which the semiconductor chip is mounted has been miniaturized to several micrometers or less.

Various methods have been proposed in order to increase the degree of circuit integration of the printed circuit board, that is, to reduce the circuit line width. For the purpose of preventing loss of the circuit line width in an etching step for forming a pattern after copper plating, a semi-additive process (SAP) method and a modified semi-additive process (MSAP) have been proposed.

Then, an embedded trace substrate (hereinafter referred to as "ETS") method for embedding a copper foil in an insulating layer in order to implement a fine circuit pattern has been used in the industry. In the ETS method, instead of forming a copper foil circuit on a surface of the insulating layer, the copper foil circuit is manufactured in an embedded form in the insulating layer, and thus there is no circuit loss due to etching and it is advantageous for miniaturizing the circuit pitch.

Meanwhile, these circuit boards include electrode parts on which semiconductor devices are mounted or for connection to external boards. The electrode part may be referred to as a metal post.

At this time, the electrode part is formed by performing electrolytic plating on a circuit pattern disposed on an uppermost or a lowermost side of the circuit board. To this end, a seed layer for electrolytic plating of the electrode part is disposed between the circuit pattern and the electrode part.

However, the conventional circuit board as described above allows the process of removing the seed layer to proceed after the formation of the seed layer and the formation of the electrode part, and there is a problem that the protective layer (for example, solder resist) of the circuit board is damaged or a surface of the protective layer is contaminated.

In addition, since the seed layer of the conventional circuit board as described above is formed through an electroless chemical copper plating process, the adhesion with the protective layer is low, and as a result, there is a problem that the seed layer falls off from the circuit board.

*In addition, the conventional circuit board as described above has a structure in which the circuit pattern and the electrode part are connected through a seed layer that is an electroless chemical plating layer, and accordingly, there is a problem in that the electrode part is separated from the circuit pattern.

### [Disclosure]

### [Technical Problem]

The embodiment provides a circuit board with a new structure and a package board including the same.

Additionally, the embodiment provides a circuit board with improved adhesion between a circuit pattern and an electrode part and a package substrate including the same.

Additionally, the embodiment provides a circuit board that can reduce the width of an electrode part and thereby reduce a pitch between a plurality of electrode parts, and a package substrate including the same.

Technical problems to be solved by the proposed embodiments are not limited to the above-mentioned technical problems, and other technical problems not mentioned may be clearly understood by those skilled in the art to which the embodiments proposed from the following descriptions belong.

### [Technical Solution]

A circuit board according to an embodiment comprises an insulating layer; a first circuit pattern disposed on the insulating layer; a first protective layer disposed on the insulating layer and including an opening that vertically overlaps an upper surface of the first circuit pattern; a first connection part disposed in the opening; and an electrode part disposed on the first connection part, and wherein a width of an upper surface of the electrode part is smaller than a width of the opening of the first protective layer.

In addition, the first connection part includes a solder.

In addition, the electrode part does not overlap vertically with the first protective layer.

In addition, the first connection part does not overlap vertically with the first protective layer.

In addition, the width of the upper surface of the electrode part is same as a width of a lower surface of the electrode part.

In addition, the circuit board further comprises a through part passing through the insulating layer.

In addition, the first connection part includes a first portion disposed between an upper surface of the first circuit pattern and a lower surface of the electrode part, and a second portion extending upward from the first portion and disposed between a side surface of the electrode part and an inner wall of the opening of the first protective layer.

In addition, the second portion of the first connection part does not contact an upper surface of the first protective layer.

In addition, an uppermost end of the second portion of the first connection part is positioned on a same plane as the upper surface of the first protective layer.

In addition, an uppermost end of the second portion of the first connection part is positioned lower than the upper surface of the first protective layer.

In addition, the circuit board further comprises a first molding layer disposed on the first protective layer and covering a side surface of the electrode part, and the electrode part passes through the first molding layer.

In addition, the insulating layer includes a plurality of insulating layers, and the first circuit pattern protrudes on an upper surface of an uppermost insulating layer disposed at an uppermost side of the plurality of insulating layers, and the second circuit pattern is embedded in a lowermost insulating layer disposed at a lowermost side of the plurality of insulating layers.

Meanwhile, the semiconductor package according to the embodiment comprises an insulating layer; a first circuit pattern disposed on the insulating layer and including a first pad and a second pad; a first protective layer disposed on the insulating layer and including an opening vertically overlapping an upper surface of the first pad and an upper surface of the second pad; a first connection part disposed on an upper surface of the first pad vertically overlapping the opening; an electrode part disposed on an upper surface of the first connection part and having a width smaller than a width of the opening of the first protective layer; a second connection part disposed on an upper surface of the second pad vertically overlapping the opening; and a semiconductor device mounted on the second connection part.

In addition, the semiconductor package includes a first molding layer disposed on the insulating layer and covering a side surface of the electrode part, and the first molding layer includes a cavity in a region that vertically overlaps the chip, and the chip is disposed in the cavity of the first molding layer.

In addition, the semiconductor package includes a second molding layer disposed in the cavity of the first molding layer and covering the chip.

In addition, the first molding layer and the second molding layer include different insulating materials.

In addition, the semiconductor package further comprises a second circuit pattern disposed at a lower surface of the insulating layer; a second protective layer disposed on the lower surface of the insulating layer and including an opening that vertically overlaps the lower surface of the second circuit pattern; and a third connection part disposed on the lower surface of the second circuit pattern vertically overlapping the opening of the second protective layer.

In addition, the semiconductor package further comprises a fourth connection part disposed on the upper surface of the electrode part; and an external board coupled to the fourth connection part.

### [Advantageous Effects]

A circuit board according to an embodiment includes an electrode part. The electrode part may function as a mounting portion on which a chip is mounted, or an attachment portion to which an external substrate is attached. For example, the electrode part may also be referred to as a post bump. At this time, the electrode part may be disposed at a certain height on the first circuit pattern. Also, a first connection part is disposed between an electrode part and a first circuit pattern. At this time, the first connection part is a bonding layer for bonding the electrode part to the first circuit pattern. Specifically, in a circuit board in a comparative example, a seed layer of the electrode part is disposed between the first circuit pattern and the electrode part. In contrast, the embodiment has a structure in which a seed layer of the electrode part is not disposed between the first circuit patterns of the electrode part. For example, the embodiment has a structure in which the electrode part and the first circuit pattern are interconnected through a first connection part such as solder paste. Accordingly, the embodiment can improve the physical and electrical reliability of the circuit board by replacing the seed layer, which is the chemical copper plating layer of the comparative example, with the first connection part. For example, the embodiment allows the electrode part to be formed using a connection part with a higher metal density compared to a chemical copper plating layer, and accordingly, it is possible to prevent the connection part from being damaged by external shock, and thereby improve physical reliability. For example, the embodiment allows the electrode part to be formed using a connection part that has high adhesion to the protective layer compared to the chemical copper plating layer, and accordingly, it is possible to solve the problem of the connection part and the electrode part being separated from the circuit board, thereby improving physical or electrical reliability. For example, the embodiment may allow a de-smear process required in a process of forming an electrode part using the chemical copper plating layer in the comparative example to be omitted, and accordingly, it can solve problems such as surface contamination of the protective layer that may occur in the de-smear process.

Meanwhile, the electrode part of the embodiment is formed from a separate electrode substrate and is bonded to the first circuit board with the connection part as a bonding layer, and accordingly, there are no restrictions in forming a width of the electrode part. For example, the comparative example had to consider a width of a dry film exposure and development depending on a width of an opening of the protective layer to form the electrode part, and accordingly, the width of the upper surface of the electrode part was formed to be greater than the width of the lower surface. In contrast, the embodiment does not have the same restrictions as in the comparative example above, and accordingly, the width of the upper and lower surfaces of the electrode part can be made the same. Furthermore, in an embodiment, the width of the upper and lower surfaces of the electrode part may be smaller than the width of the opening of the protective layer. Accordingly, the embodiment can reduce a separation distance between a plurality of electrode parts. Through this, the embodiment can improve the circuit integration of the circuit board and further reduce a size of the circuit board in a horizontal direction or a vertical direction.

### [Description of Drawings]

FIG. 1 is a view showing a circuit board of a comparative example.
FIG. 2A is a cross-sectional view illustrating a semiconductor package according to a first embodiment.
FIG. 2B is a cross-sectional view illustrating a semiconductor package according to a second embodiment.
FIG. 2C is a cross-sectional view illustrating a semiconductor package according to a third embodiment.
FIG. 2D is a cross-sectional view illustrating a semiconductor package according to a fourth embodiment.
FIG. 2E is a cross-sectional view illustrating a semiconductor package according to a fifth embodiment.
FIG. 2F is a cross-sectional view illustrating a semiconductor package according to a sixth embodiment.
FIG. 2G is a cross-sectional view illustrating a semiconductor package according to a seventh embodiment.
FIG. 3 is a view showing a circuit board according to an embodiment.
FIG. 4 is an enlarged view of an electrode part of FIG. 3 according to a first embodiment.
FIG. 5 is an enlarged view of an electrode part of FIG. 3 according to a second embodiment.
FIG.6 is a view showing a package substrate according to a first embodiment.
FIG. 7 is a view showing a package substrate according to a second embodiment.
FIG.8 is a view showing a package substrate according to a third embodiment.
FIGS. 9 to 22 are views for explaining a method of manufacturing a circuit board shown in FIG. 3 in order of process.

### [Best Mode]

Hereinafter, embodiments of the present disclosure will be described in detail with reference to the accompanying drawings.

However, the spirit and scope of the present disclosure is not limited to a part of the embodiments described, and may be implemented in various other forms, and within the spirit and scope of the present disclosure, one or more of the elements of the embodiments may be selectively combined and replaced.

In addition, unless expressly otherwise defined and described, the terms used in the embodiments of the present disclosure (including technical and scientific terms) may be construed the same meaning as commonly understood by one of ordinary skill in the art to which the present disclosure belongs, and the terms such as those defined in commonly used dictionaries may be interpreted as having a meaning that is consistent with their meaning in the context of the relevant art. In addition, the terms used in the embodiments of the present disclosure are for describing the embodiments and are not intended to limit the present disclosure.

In this specification, the singular forms may also include the plural forms unless specifically stated in the phrase, and may include at least one of all combinations that may be combined in A, B, and C when described in "at least one (or more) of A (and), B, and C". Further, in describing the elements of the embodiments of the present disclosure, the terms such as first, second, A, B, (a), and (b) may be used.

These terms are only used to distinguish the elements from other elements, and the terms are not limited to the essence, order, or order of the elements. In addition, when an element is described as being "connected", "coupled", or "contacted" to another element, it may include not only when the element is directly "connected" to, "coupled" to, or "contacted" to other elements, but also when the element is "connected", "coupled", or "contacted" by another element between the element and other elements.

In addition, when described as being formed or disposed "on (over)" or "under (below)" of each element, the "on (over)" or "under (below)" may include not only when two elements are directly connected to each other, but also when one or more other elements are formed or disposed between two elements. Further, when expressed as "on (over)" or "under (below)", it may include not only the upper direction but also the lower direction based on one element.

### -comparative example -

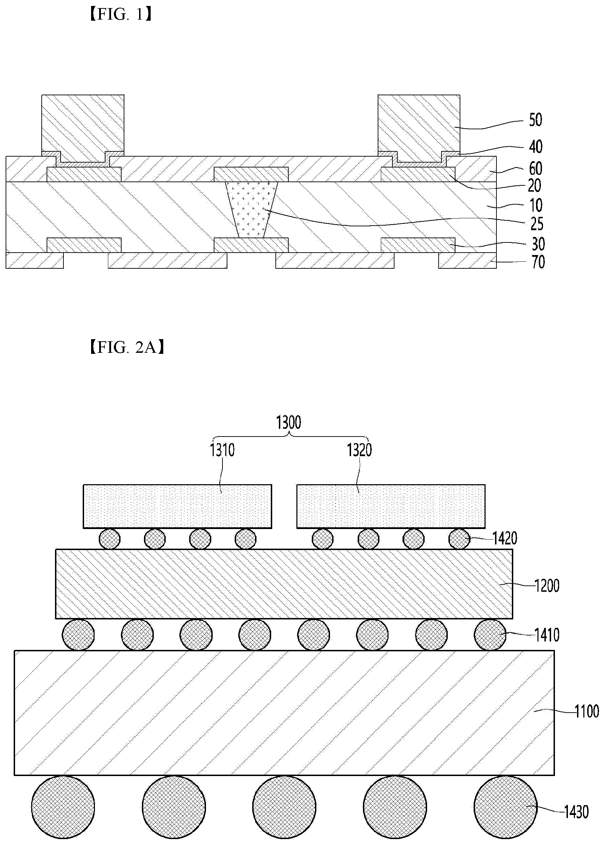

FIG. 1 is a view showing a circuit board according to a comparative example.

Referring to FIG. 1, a circuit board of the comparative example has an Embedded Trace Substrate (ETS) structure. For example, the circuit board of the comparative example includes first and second outermost layer circuit patterns disposed at uppermost and lowermost sides. In addition, one of the first and second outermost layer circuit patterns has a structure in which at least a portion is buried within the insulating layer, and other portion has a structure that protrudes from a surface of the insulating layer.

Specifically, the circuit board of the comparative example includes an insulating layer 10.

In addition, a first circuit pattern 20 is disposed on an upper surface of the insulating layer 10. Additionally, a second circuit pattern 30 is disposed on a lower surface of the insulating layer 10.

At this time, the insulating layer 10 may have a single-layer structure or, alternatively, may have a plurality of layers.

Also, when the insulating layer 10 has a multi-layer structure, the first circuit pattern 20 may be disposed on an upper surface of an insulating layer disposed an uppermost side among the insulating layers of the multi-layer structure. Additionally, when the insulating layer 10 has a plurality of layer structure, the second circuit pattern 30 may be disposed a lower surface of the insulating layer disposed at a lowest side among the insulating layers of the plurality of layers.

At this time, the first circuit pattern 20 may have a structure that protrudes on the upper surface of the insulating layer 10. Alternatively, the second circuit pattern 30 may have a structure embedded in the insulating layer 10. For example, at least a portion of a side surface of the second circuit pattern 30 may be covered with the insulating layer 10.

In addition, the circuit board of the comparative example includes a through part 25 that passes the insulating layer 10. The through part 25 may also be referred to as a 'via' or a through electrode that passes through the insulating layer 10.

The through part 25 passes through the insulating layer, and accordingly, it may have a structure that electrically connects the first circuit pattern 20 disposed on the upper surface of the insulating layer 10 and the second circuit pattern 30 disposed on the lower surface of the insulating layer 10. For example, the upper surface of the through part 25 is directly connected to the lower surface of the first circuit pattern 20, and a lower surface of the through part 25 may be directly connected to the upper surface of the second circuit pattern 30.

Meanwhile, the circuit board of the comparative example includes an electrode part 50. The electrode part 50 may be disposed at a certain height on the upper surface of the first circuit pattern 20.

For example, the circuit board of the comparative example includes a first protective layer 60 disposed on the upper surface of the insulating layer 10 and a second protective layer 70 disposed on the lower surface of the insulating layer 10. The first protective layer 60 and the second protective layer 70 may be a solder resist.

The first protective layer 60 may protect an upper surface of the insulating layer 10 and an upper surface of the first circuit pattern 20. Additionally, the second protective layer 70 may protect a lower surface of the insulating layer 10 and a lower surface of the second circuit pattern 30.

The first protective layer 60 may include a first opening that vertically overlaps the upper surface of the first circuit pattern 20 . For example, the first circuit pattern 20 may include a first pad. Additionally, the first protective layer 60 may include a first opening that vertically overlaps the upper surface of the first pad of the first circuit pattern 20. A width of the first opening may be smaller than a width of the first pad of the first circuit pattern 20. Accordingly, at least a portion of the upper surface of the first pad of the first circuit pattern 20 may be covered with the first protective layer 60.

Correspondingly, the second protective layer 70 includes a second opening that vertically overlaps the lower surface of the second circuit pattern 30.

Meanwhile, the electrode part 50 is disposed on the upper surface of the first circuit pattern 20 that vertically overlaps the first opening of the first protective layer 60.

At this time, the electrode part 50 may be formed to have a certain height by performing electrolytic plating on the first circuit pattern 20.

To this end, a seed layer 40 is disposed between the electrode part 50 and the first circuit pattern 20. The seed layer 40 may be a chemical copper plating layer formed through an electroless plating process.

Additionally, the electrode part 50 and the first circuit pattern 20 are physically and/or electrically connected to each other using the seed layer 40 as a connection layer.

Meanwhile, the seed layer 40 is disposed on each an upper surface of the first circuit pattern 20 vertically overlaps the first opening of the first protective layer 60, an inner wall of the first opening of the first protective layer 60, and an upper surface of the first protective layer 60.

Meanwhile, the circuit board of this comparative example has a problem of low physical or electrical reliability of the electrode part 50.

The electrode part 50 must have a certain height and can be formed by electroless plating accordingly. Accordingly, the electrode part 50 is formed by electrolytic plating, and for this purpose, a seed layer for electrolytic plating of the electrode part 50 is disposed between the electrode part 50 and the first circuit pattern 20.

At this time, the seed layer 40 before electrolytic plating of the electrode part 50 it is disposed on an entire upper surface of the first protective layer 60, an inner wall of the first opening, and the upper surface of the first circuit pattern 20, respectively, in the state where the first protective layer 60 is formed.

Then, when electrolytic plating of the electrode part 50 using the seed layer 40 is completed, a process of removing a portion of the seed layer 40 is performed. For example, when the electrolytic plating of the electrode part 50 is completed, a process of removing a region that does not vertically overlap the electrode part 50 among the entire regions of the seed layer 40 is performed.

The process of removing the seed layer 40 includes a de-smear process.

At this time, when the de-smear process is performed, there is a problem that the upper surface of the first protective layer 60 is contaminated by the solution used in the de-smear process. For example, when the de-smear process is performed, a whitening phenomenon occurs in which the surface of the first protective layer 60 turns white due to the solution, and this has the problem of spoiling the aesthetics of the circuit board.

Meanwhile, the seed layer 40 as described above is a chemical copper plating layer formed by electroless plating. And, the chemical copper plating layer has a porous structure.

At this time, the porous structure has a low density of metal, and as a result, there is a problem that cracks easily occur due to external shock or other physical forces. Accordingly, in the comparative example, cracks occur in the seed layer 40 due to external impact, and accordingly, damage is transmitted to the electrode part 50, and as a result, a durability problem in which the electrode part 50 is destroyed may occur.

In addition, the seed layer 40 has low adhesion or bonding force with the first protective layer 60 formed of the solder resist. Accordingly, there is a problem in which the seed layer 40 is delaminated from the first protective layer 60 when the electrode part 50 is formed, and accordingly, physical reliability and electrical reliability problems may occur as the electrode part 50 is separated into the first circuit pattern 20.

Furthermore, the electrode part 50 in the comparative example has different upper and lower widths. For example, in the comparative example, the width of the upper surface of the electrode part 50 is formed to be larger than the width of the first opening of the first protective layer 60 due to limitations in a process. That is, forming a dry film (not shown) on the seed layer 40 and thereby forming a second opening corresponding to the electrode part 50 in the dry film must be performed for electrolytic plating of the electrode part 50. At this time, the dry film is disposed on the first protective layer 60 in which the first opening is formed, and accordingly, the second opening of the dry film has a width greater than the width of the first opening of the first protective layer 60. Accordingly, the width of the upper surface of the electrode part 50 is larger than the width of the first opening of the first protective layer 60, and the upper surface of the first protective layer 60 has a formation extending in the longitudinal or width direction. Accordingly, in the circuit board of the comparative example, there is a limit to reducing the width of the electrode part 50, and there is a problem in that circuit integration decreases as the pitch between a plurality of electrode parts increases.

Accordingly, the embodiment makes it possible to solve the problems of the circuit board of the comparative example above. For example, the embodiment allows a seed layer of an electrode part disposed between a first circuit pattern and an electrode part to be removed. For example, the embodiment allows a chemical copper plating layer between the first circuit board and the electrode part to be removed. For example, in the embodiment, a width of an upper surface of an electrode part is smaller than a width of a first opening of the first protective layer. For example, in the embodiment, a width of an upper surface of the electrode part is equal to a width of a lower surface of the electrode part.

### -Electronic device-

Before describing the embodiment, an electronic device to which the semiconductor package of the embodiment is applied will be briefly described. The electronic device includes a main board (not shown). The main board may be physically and/or electrically connected to various components. For example, the main board may be connected to the semiconductor package of the embodiment. Various semiconductor devices may be mounted on the semiconductor package.

The semiconductor device may include an active device and/or a passive device. The active device may be a semiconductor chip in the form of an integrated circuit (IC) in which hundreds to millions of devices are integrated in one chip. The semiconductor device may be a logic chip, a memory chip, or the like. The logic chip may be a central processor (CPU), a graphics processor (GPU), or the like. For example, the logic chip may be an application processor (AP) chip including at least one of a central processor (CPU), a graphics processor (GPU), a digital signal processor, a cryptographic processor, a microprocessor and a microcontroller, or an analog-digital converter, an application-specific IC (ASIC), or the like, or a chip set comprising a specific combination of those listed so far.

The memory chip may be a stack memory such as HBM. The memory chip may also include a memory chip such as volatile memory (e.g., DRAM), non-volatile memory (e.g., ROM), flash memory, and the like.

On the other hand, a product group to which the semiconductor package of the embodiment is applied may be any one of CSP (Chip Scale Package), FC-CSP (Flip Chip-Chip Scale Package), FC-BGA (Flip Chip Ball Grid Array), POP (Package on Package) and SIP (System in Package), but is not limited thereto.

In addition, the electronic device may be a smart phone, a personal digital assistant, a digital video camera, a digital still camera, a vehicle, a highperformance server, a network system, computer, monitor, tablet, laptop, netbook, television, video game, smart watch, automotive, or the like. However, the embodiment is not limited thereto, and may be any other electronic device that processes data in addition to these.

Hereinafter, a semiconductor package including a circuit board according to an embodiment will be described. The semiconductor package of the embodiment may have various package structures including a circuit board to be described later.

In addition, a circuit board in one embodiment may be a first board described below.

In addition, a circuit board in another embodiment may be a second board described below.

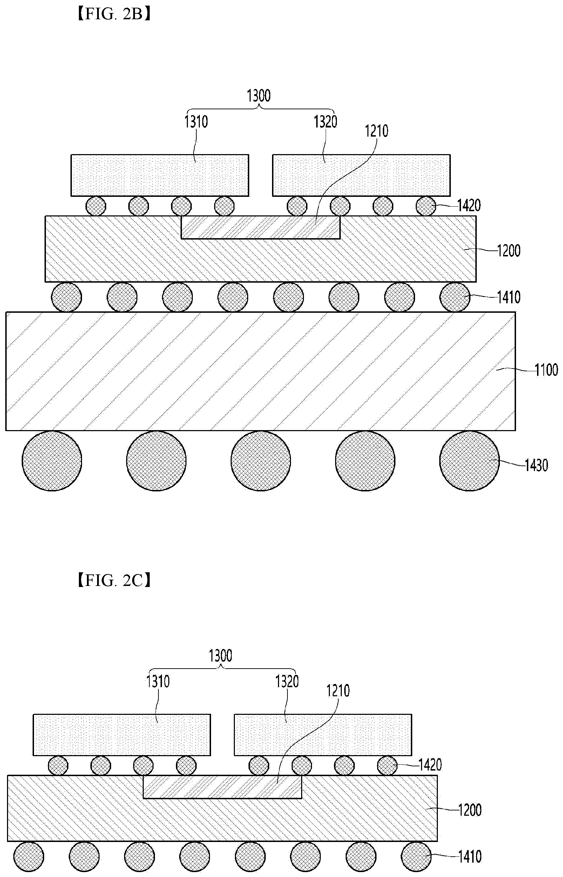

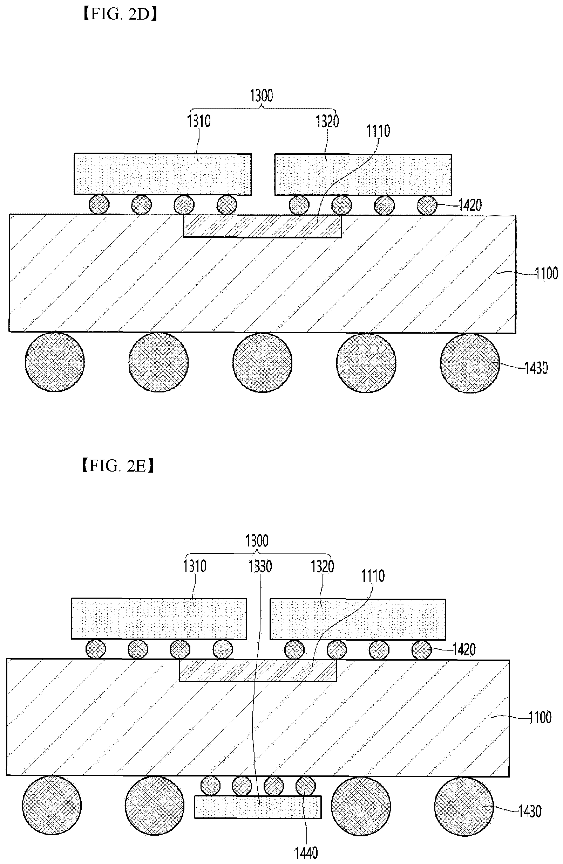

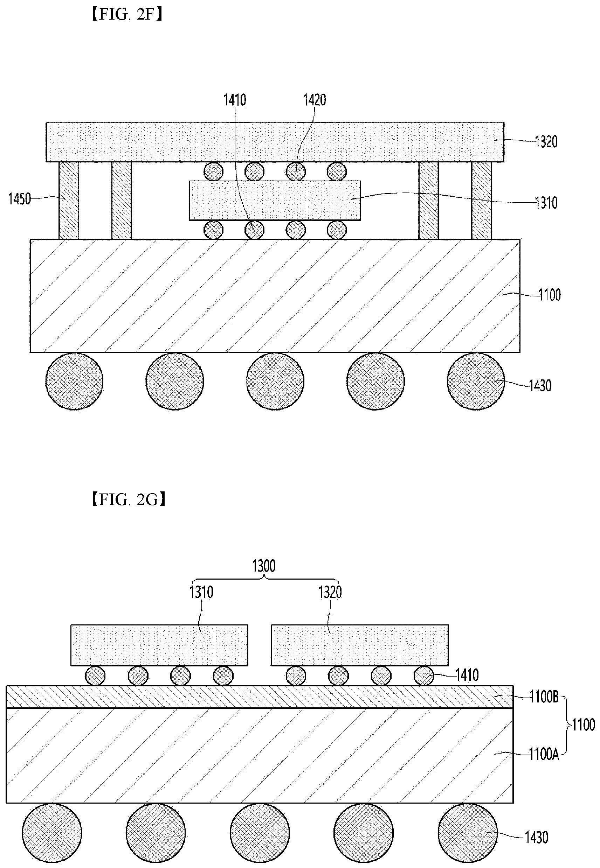

FIG. 2A is a cross-sectional view illustrating a semiconductor package according to a first embodiment, FIG. 2B is a cross-sectional view illustrating a semiconductor package according to a second embodiment, FIG. 2C is a cross-sectional view illustrating a semiconductor package according to a third embodiment, FIG. 2D is a cross-sectional view illustrating a semiconductor package according to a fourth embodiment, FIG. 2E is a cross-sectional view illustrating a semiconductor package according to a fifth embodiment, FIG. 2F is a cross-sectional view illustrating a semiconductor package according to a sixth embodiment, and FIG. 2G is a cross-sectional view illustrating a semiconductor package according to a seventh embodiment.

Referring to FIG. 2A, the semiconductor package according to the first embodiment may include a first circuit board 1100, a second circuit board 1200, and a semiconductor device 1300.

The first circuit board 1100 may mean a package substrate.

For example, the first circuit board 1100 may provide a space to which at least one external substrate is coupled. The external substrate may refer to a second circuit board 1200 coupled to the first circuit board 1100. Also, the external substrate may refer to a main board included in an electronic device coupled to a lower portion of the first circuit board 1100.

Also, although not shown in the drawing, the first circuit board 1100 may provide a space in which at least one semiconductor device is mounted.

The first circuit board 1100 may include at least one insulating layer, an electrode disposed on the at least one insulating layer, and a through electrode passing through the at least one insulating layer.

A second circuit board 1200 may be disposed on the first circuit board 1100.

The second circuit board 1200 may be an interposer. For example, the second circuit board 1200 may provide a space in which at least one semiconductor device is mounted. The second circuit board 1200 may be connected to the at least one semiconductor device 1300. For example, the second circuit board 1200 may provide a space in which the first semiconductor device 1310 and the second semiconductor device 1320 are mounted. The second circuit board 1200 may electrically connect the first and second semiconductor devices 1310 and 1320 and the first circuit board 1100 while electrically connecting the first semiconductor device 1310 and the second semiconductor device 1320. That is, the second circuit board 1200 may perform a horizontal connection function between a plurality of semiconductor devices and a vertical connection function between the semiconductor devices and the package substrate.

FIG. 2A illustrates that the first and second semiconductor devices 1310 and 1320 are disposed on the second circuit board 1200, but is not limited thereto. For example, one semiconductor device may be disposed on the second circuit board 1200, or alternatively, three or more semiconductor devices may be disposed.

The second circuit board 1200 may be disposed between at least one of the semiconductor device 1300 and the first circuit board 1100.

In one embodiment, the second circuit board 1200 may be an active interposer that functions as a semiconductor device. When the second circuit board 1200 functions as a semiconductor device, the semiconductor package of the embodiment may have a vertical stack structure on the first circuit board 1100 and function as a plurality of logic chips. Being able to have the functions of a logic chip may mean having the functions of an active device and a passive device. In the case of active devices, unlike passive devices, current and voltage characteristics may not be linear, and in the case of an active interposer, it can have the function of an active device. Additionally, the active interposer may function as a corresponding logic chip and perform a signal transmission function between the first circuit board 1100 and a second logic chip disposed on an upper portion of the active interposer.

According to another embodiment, the second circuit board 1200 may be a passive interposer. For example, the second circuit board 1200 may function as a signal relay between the semiconductor device 1300 and the first circuit board 1100, and may have passive device functions such as a resistor, capacitor, and inductor. For example, a number of terminals of the semiconductor device 1300 is gradually increasing due to 5G, Internet of Things (IOT), increased image quality, and increased communication speed. That is, the number of terminals provided in the semiconductor device 1300 increases, thereby reducing the width of the terminals or an interval between the plurality of terminals. In this case, the first circuit board 1100 may be connected to the main board of the electronic device. There is a problem in that the thickness of the first circuit board 1100 increases or the layer structure of the first circuit board 1100 becomes complicated in order for the electrodes provided on the first circuit board 1100 to have a width and an interval to be respectively connected to the semiconductor device 1300 and the main board. Accordingly, in the first embodiment, the second circuit board 1200 may be disposed on the first circuit board 1100 and the semiconductor device 1300. In addition, the second circuit board 1200 may include electrodes having a fine width and an interval corresponding to the terminals of the semiconductor device 1300.
the semiconductor device 1300 may be an application processor (AP) chip including at least one of a central processor (CPU), a graphics processor (GPU), a digital signal processor, a cryptographic processor, a microprocessor and a microcontroller, or an analog-digital converter, an application-specific IC (ASIC), or the like, or a chip set comprising a specific combination of those listed so far. The memory chip may be a stack memory such as HBM. The memory chip may also include a memory chip such as volatile memory (e.g., DRAM), non-volatile memory (e.g., ROM), flash memory, and the like.

Meanwhile, the semiconductor package of the first embodiment may include a connection part.

For example, the semiconductor package may include a first connection part 1410 disposed between the first circuit board 1100 and the second circuit board 1200. The first connection part 1410 may electrically connect the second circuit board 1200 to the first circuit board 1100 while coupling them.

For example, the semiconductor package may include the second connection part 1420 disposed between the second circuit board 1200 and the semiconductor device 1300. The second connection part 1420 may electrically connect the semiconductor device 1300 to the second circuit board 1200 while coupling them.

The semiconductor package may include a third connection part 1430 disposed on a lower surface of the first circuit board 1100. The third connection part 1430 may electrically connect the first circuit board 1100 to the main board while coupling them.

At this time, the first connection part 1410, the second connection part 1420, and the third connection part 1430 may electrically connect between the plurality of components by using at least one bonding method of wire bonding, solder bonding and metal-to-metal direct bonding. That is, since the first connection part 1410, the second connection part 1420, and the third connection part 1430 have a function of electrically connecting a plurality of components, when the metal-to-metal direct bonding is used, the connection part of the semiconductor package may be understood as an electrically connected portion, not a solder or wire.

The wire bonding method may refer to electrically connecting a plurality of components using a conductive wire such as gold (Au). Also, the solder bonding method may electrically connect a plurality of components using a material containing at least one of Sn, Ag, and Cu. In addition, the metal-to-metal direct bonding method may refer to recrystallization by applying heat and pressure between a plurality of components without the presence of solder, wire, conductive adhesive, etc. and to directly bond between the plurality of components. In addition, the metal-to-metal direct bonding method may refer to a bonding method by the second connection part 1420. In this case, the second connection part 1420 may mean a metal layer formed between a plurality of components by the recrystallization.

Specifically, the first connection part 1410, the second connection part 1420, and the third connection part 1430 may couple a plurality of components to each other by a thermal compression (TC) bonding method. The TC bonding may refer to a method of directly coupling a plurality of components by applying heat and pressure to the first connection part 1410, the second connection part 1420, and the third connection part 1430.

In this case, at least one of the first circuit board 1100 and the second circuit board 1200 may include a protrusion provided in the electrode on the first connection part 1410, the second connection part 1420, and the third connection part 1430 are disposed. The protrusion may protrude outward from the first circuit board 1100 or the second circuit board 1200.

The protrusion may be referred to as an electrode portion described in the circuit board below. In addition, the protrusion may be referred to as a bump. The protrusion may also be referred to as a post. The protrusion may also be referred to as a pillar. Preferably, the protrusion may refer to an electrode on which a second connection part 1420 for coupling with the semiconductor device 1300 is disposed among the electrodes of the second circuit board 1200. That is, the pitch of the terminals of the semiconductor device 1300 is becoming finer, as a result, a short circuit may occur between the plurality of second connection parts 1420 respectively connected to the plurality of terminals of the semiconductor device 1300 by a conductive adhesive such as solder. Accordingly, the embodiment may perform thermal compression bonding to reduce the volume of the second connection part 1420. Accordingly, the embodiment may include a protrusion in the electrode of the second circuit board 1200 on which the second connection part 1420 is disposed in order to secure position accuracy and diffusion prevention power to prevent the intermetallic compound (IMC) formed between a conductive adhesive such as solder and a protrusion from diffusing to the interposer and/or the circuit board.

Meanwhile, referring to FIG. 2B, the semiconductor package of the second embodiment may differ from the semiconductor package of the first embodiment in that the connecting member 1210 is disposed on the second circuit board 1200. The connecting member 1210 may be referred to as a bridge substrate. For example, the connecting member 1210 may include a redistribution layer. The connecting member 1210 may function to electrically connect a plurality of semiconductor devices to each other horizontally. For example, an area that a semiconductor device should have, is generally too large, and for this reason, the connecting member 1210 may include a redistribution layer. The semiconductor package and the semiconductor device have significant differences in a width and a spacing of their circuit patterns, and for this reason, a buffering role of the circuit pattern for electrical connection is necessary. The buffering role may mean having an intermediate size between the width or spacing of the circuit pattern of the semiconductor package and the width or spacing of the circuit pattern of the semiconductor device, and the redistribution layer may include a function that acts as a buffer.

In an embodiment, the connecting member 1210 may be a silicon bridge. That is, the connecting member 1210 may include a silicon substrate and a redistribution layer disposed on the silicon substrate.

In another embodiment, the connecting member 1210 may be an organic bridge. For example, the connecting member 1210 may include an organic material. For example, the connecting member 1210 may include an organic substrate including an organic material instead of the silicon substrate.

The connecting member 1210 may be embedded in the second circuit board 1200, but is not limited thereto. For example, the connecting member 1210 may be disposed on the second circuit board 1200 to have a protruding structure.

Also, the second circuit board 1200 may include a cavity, and the connecting member 1210 may be disposed in the cavity of the second circuit board 1200.

The connecting member 1210 may horizontally connect a plurality of semiconductor devices disposed on the second circuit board 1200.

Referring to FIG. 2C, the semiconductor package according to the third embodiment may include a second circuit board 1200 and a semiconductor device 1300. In this case, the semiconductor package of the third embodiment may have a structure in which the first circuit board 1100 is removed compared to the semiconductor package of the second embodiment.

That is, the second circuit board 1200 of the third embodiment may function as a package substrate while performing an interposer function.

The first connection part 1410 disposed on the lower surface of the second circuit board 1200 may couple the second circuit board 1200 to the main board of the electronic device.

Referring to FIG. 2D, the semiconductor package according to the fourth embodiment may include a first circuit board 1100 and a semiconductor device 1300.

In this case, the semiconductor package of the fourth embodiment may have a structure in which the second circuit board 1200 is omitted compared to the semiconductor package of the second embodiment.

That is, the first circuit board 1100 of the fourth embodiment may function as a connection between the semiconductor device 1300 and the main board while functioning as a package substrate. To this end, the first circuit board 1100 may include a connecting member 1110 for connecting the plurality of semiconductor devices. The connecting member 1110 may be a silicon bridge or an organic material bridge connecting a plurality of semiconductor devices.

Referring to FIG. 2E, the semiconductor package of the fifth embodiment may further include a third semiconductor device 1330 compared to the semiconductor package of the fourth embodiment.

To this end, a fourth connection part 1440 may be disposed on the lower surface of the first circuit board 1100.

In addition, a third semiconductor device 1330 may be disposed on the fourth connection part1400. That is, the semiconductor package of the fifth embodiment may have a structure in which semiconductor devices are mounted on upper and lower sides, respectively.

In this case, the third semiconductor device 1330 may have a structure disposed on the lower surface of the second circuit board 1200 in the semiconductor package of FIG. 2C.

Referring to FIG. 2F, the semiconductor package according to the sixth embodiment may include a first circuit board 1100. A first semiconductor device 1310 may be disposed on the first circuit board 1100. To this end, a first connection part 1410 may be disposed between the first circuit board 1100 and the first semiconductor device 1310.

In addition, the first circuit board 1100 may include a conductive coupling portion 1450. The conductive coupling portion 1450 may further protrude from the first circuit board 1100 toward the second semiconductor device 1320. The conductive coupling portion 1450 may be referred to as a bump or, alternatively, may also be referred to as a post. The conductive coupling portion 1450 may be disposed to have a protruding structure on an electrode disposed on an uppermost side of the first circuit board 1100.

A second semiconductor device 1320 may be disposed on the conductive coupling portion 1450. In this case, the second semiconductor device 1320 may be connected to the first circuit board 1100 through the conductive coupling portion 1450. In addition, a second connection part 1420 may be disposed on the first semiconductor device 1310 and the second semiconductor device 1320.

Accordingly, the second semiconductor device 1320 may be electrically connected to the first semiconductor device 1310 through the second connection part 1420.

That is, the second semiconductor device 1320 may be connected to the first circuit board 1100 through the conductive coupling portion 1450, and may be also connected to the first semiconductor device 1310 through the second connection part 1420.

In this case, the second semiconductor device 1320 may receive a power signal and/or an electrical power through the conductive coupling portion 1450. Also, the second semiconductor device 1320 may transmit and receive a communication signal to and from the first semiconductor device 1310 through the second connection part 1420.

The semiconductor package according to the sixth embodiment provides a power signal and/or an electrical power to the second semiconductor device 1320 through the conductive coupling portion 1450, and it may be possible to provide sufficient power for driving the second semiconductor device 1320 or to smoothly control power supply operation.

Accordingly, the embodiment may improve the driving characteristics of the second semiconductor device 1320. That is, the embodiment may solve the problem of insufficient power provided to the second semiconductor device 1320. Furthermore, in the embodiment, at least one of the power signal, the electrical power and the communication signal of the second semiconductor device 1320 may be provided through different paths through the conductive coupling portion 1450 and the second connection part 1420. Through this, the embodiment can solve the problem that the communication signal is lost due to the power signal. For example, the embodiment may minimize mutual interference between communication signals of power signals.

Meanwhile, the second semiconductor device 1320 in the sixth embodiment may have a POP (Package On Package) structure in which a plurality of package substrates are stacked and may be disposed on the first substrate 1100. For example, the second semiconductor device 1320 may be a memory package including a memory chip. In addition, the memory package may be coupled on the conductive coupling portion 1450. In this case, the memory package may not be connected to the first semiconductor device 1310.

Referring to FIG. 2G, the semiconductor package according to the seventh embodiment may include a first circuit board 1100, a first connection part 1410, a first connection part 1410, a semiconductor device 1300, and a third connection part 1430.

In this case, the semiconductor package of the seventh embodiment is different from the semiconductor package of the fourth embodiment in that the first circuit board 1100 includes a plurality of substrate layers while the connecting member 1110 is removed.

The first circuit board 1100 includes a plurality of substrate layers. For example, the first circuit board 1100 may include a first substrate layer 1100A corresponding to a package substrate and a second substrate layer 1100B corresponding to the connecting member.

In other words, the semiconductor package of the seventh embodiment may include a first substrate layer 1100A and a second substrate layer 1100B in which the first circuit board (package substrate, 1100) and the second circuit board (interposer, 1200) shown in FIG. 2A are integrally formed. The material of the insulating layer of the second substrate layer 1100B may be different from the material of the insulating layer of the first substrate layer 1100A. For example, the material of the insulating layer of the second substrate layer 1100B may include a photocurable material. For example, the second substrate layer 1100B may be a photo imageable dielectric (PID). In addition, since the second substrate layer 1100B includes a photocurable material, it is possible to miniaturize the electrode. Accordingly, in the seventh embodiment, the second substrate layer 1100B may be formed by sequentially stacking an insulating layer of a photo-curable material on the first substrate layer 1100A and forming a miniaturized electrode on the insulating layer of the photo-curable material. Through this, the second circuit board 1100B may be a redistribution layer including a miniaturized electrode and include a function to horizontally connect a plurality of semiconductor devices 1310 and 1320.

### -Circuit board-

Hereinafter, the circuit board of the embodiment will be described.

Before describing the circuit board of the embodiment, the circuit board described below may mean any one of a plurality of circuit boards included in the previous semiconductor package.

For example, in an embodiment, a circuit board described below may refer to the first circuit board 1100, the second circuit board 1200, and the connecting member (or bridge substrate, 1110 and 1210) shown in any one of FIGS. 2A to 2G.

A electrode part 160 described below may refer to a conductive coupling portion or protrusion coupled to any one of the first circuit board, the second circuit board, the connecting member, and the semiconductor device.

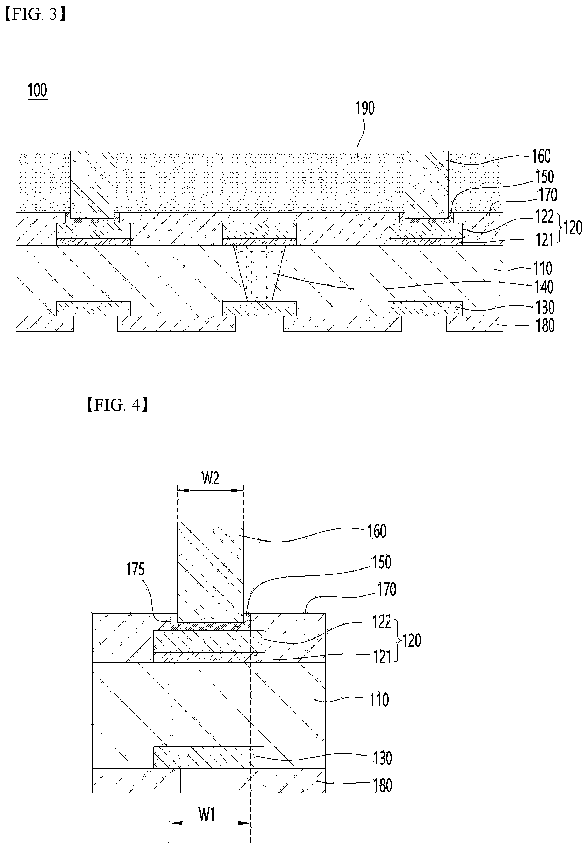

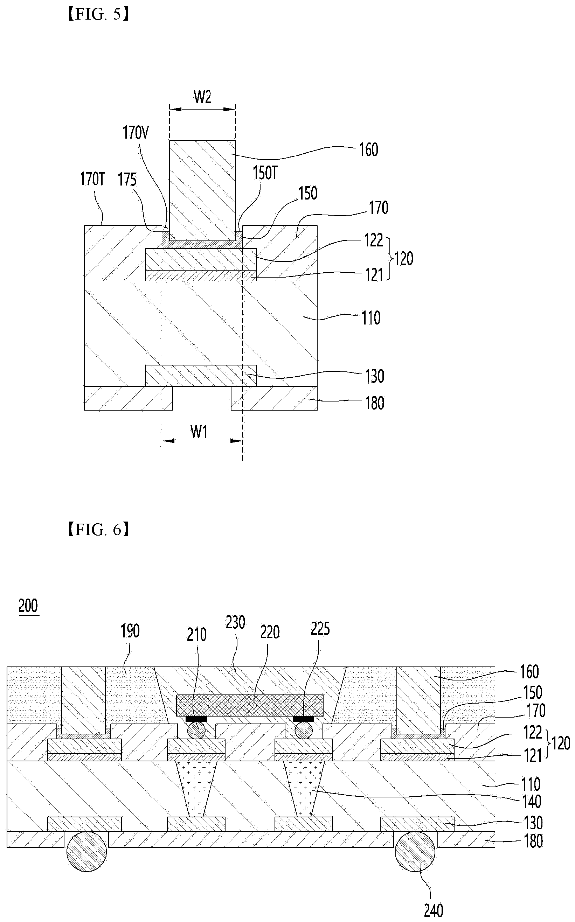

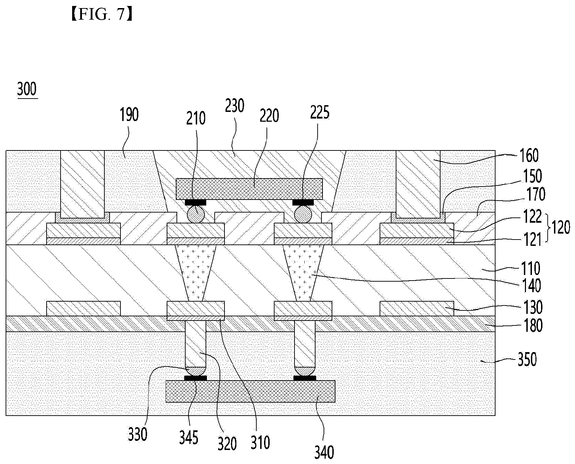

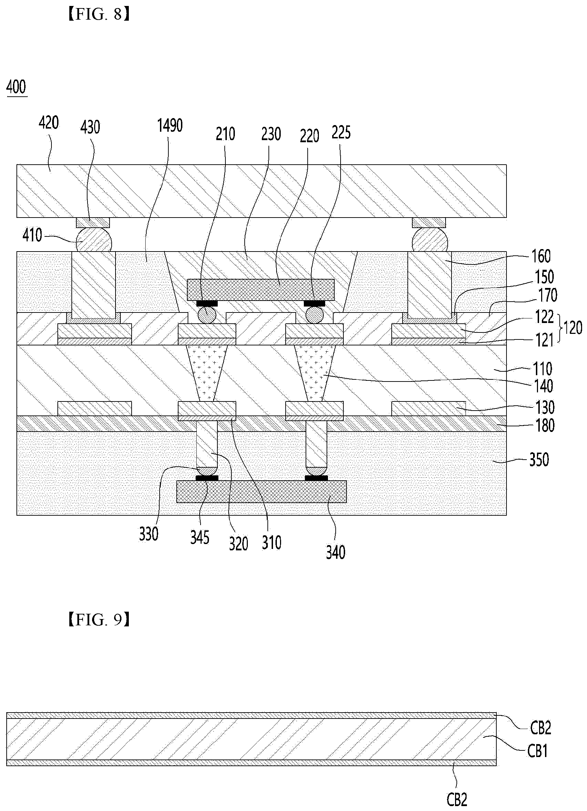

FIG. 3 is a view showing a circuit board according to an embodiment, FIG. 4 is an enlarged view of an electrode part of FIG. 3 according to a first embodiment, FIG. 5 is an enlarged view of an electrode part of FIG. 3 according to a second embodiment, FIG.6 is a view showing a package substrate according to a first embodiment, FIG. 7 is a view showing a package substrate according to a second embodiment, and FIG.8 is a view showing a package substrate according to a third embodiment.

Hereinafter, a structure of the electrode part of the circuit board of the embodiment will be described in detail with reference to FIGS. 3 to 8, and the package substrate including the same will be described in detail. The package substrate may refer to some components of the semiconductor package described in FIGS. 1A to 2G.

The circuit board of the embodiment includes an insulating layer 110, a first circuit pattern 120, a second circuit pattern 130, a through part 140, a connection part 150, an electrode part 160, a first protective layer 170, a second protective layer 180, and a first molding layer 190.

At this time, in FIG. 3, the circuit board 100 is shown as having a one-layer structure based on the number of insulating layers 110, but the circuit board 100 is not limited to this.

For example, the circuit board 100 may have a multi-layer structure of two or more layers based on the number of insulating layers 110.

Hereinafter, the circuit board will be described as having a one-layer structure based on the number of insulating layers 110 for convenience of explanation.

Meanwhile, when the insulating layer 110 has a multi-layer structure, the insulating layer 110 in FIG. 2 may represent an uppermost insulating layer disposed at an uppermost side among the insulating layers of the multi-layer structure.

Also, when the insulating layer 110 has a multi-layer structure, the first circuit pattern 120 in FIG. 2 may represent an uppermost circuit pattern disposed on the uppermost insulating layer. Additionally, when the insulating layer 110 has a multi-layer structure, the second circuit pattern 130 in FIG. 2 may represent a lowermost circuit pattern disposed on the lower surface of the lowermost insulating layer. At this time, the circuit board of the embodiment is manufactured by the ETS method. Additionally, the first circuit pattern 120 may be disposed at a surface of the uppermost insulating layer, which is formed last in the ETS method. For example, the first circuit pattern 120 may refer to a circuit pattern formed last among circuit patterns arranged in different layers. Additionally, the second circuit pattern 130 may be embedded in the lowermost insulating layer that is formed first in the ETS method. For example, the second circuit pattern 130 may refer to a circuit pattern formed first among circuit patterns arranged in different layers.

That is, the circuit board includes an insulating layer 110.

The insulating layer 110 has a layer structure of at least one layer.

The insulating layer 110 may include prepreg (PPG, prepreg). The prepreg may be formed by impregnating a fiber layer in the form of a fabric sheet, such as a glass fabric woven with glass yarn, with an epoxy resin, and then performing thermocompression. However, the embodiment is not limited to this, and the prepreg constituting the insulating layer 110 may include a fiber layer in a form of a fabric sheet woven with carbon fiber yarn.

The insulating layer 110 may include a resin and a reinforcing fiber disposed in the resin. The resin may be an epoxy resin, but is not limited thereto. The resin is not particularly limited to the epoxy resin, and for example, one or more epoxy groups may be included in the molecule, or alternatively, two or more epoxy groups may be included, or alternatively, four or more epoxy groups may be included. In addition, the resin of the insulating layer 110 may include a naphthalene group, for example, may be an aromatic amine type, but is not limited thereto. For example, the resin may be include a bisphenol A type epoxy resin, a bisphenol F type epoxy resin, a bisphenol S type epoxy resin, a phenol novolac type epoxy resin, an alkylphenol novolac type epoxy resin, a biphenyl type epoxy resin, an aralkyl type epoxy resin, dicyclopentadiene type epoxy resin, naphthalene type epoxy resin, naphthol type epoxy resin, epoxy resin of condensate of phenol and aromatic aldehyde having phenolic hydroxyl group, biphenyl aralkyl type epoxy resin, fluorene type epoxy resin resins, xanthene-type epoxy resins, triglycidyl isocyanurate, rubber-modified epoxy resins, phosphorous-based epoxy resins, and the like, and naphthalene-based epoxy resins, bisphenol A-type epoxy resins, and phenol novolac epoxy resins, cresol novolak epoxy resins, rubber-modified epoxy resins, and phosphorous-based epoxy resins. In addition, the reinforcing fiber may include glass fiber, carbon fiber, aramid fiber (e.g., aramid-based organic material), nylon, silica-based inorganic material or titania-based inorganic material. The reinforcing fibers may be arranged in the resin to cross each other in a planar direction.

Meanwhile, the embodiment may use as the glass fiber, carbon fiber, aramid fiber (e.g., aramid-based organic material), nylon, silica-based inorganic material or titania-based inorganic material.

However, the embodiment is not limited to this, and the insulating layer 110 may include other insulating materials.

For example, the insulating layer 110 may be rigid or flexible. For example, the insulating layer 110 may include glass or plastic. Specifically, the insulating layer 110 may include a chemically tempered/semi-tempered glass, such as soda lime glass, aluminosilicate glass, etc., a tempered or flexible plastic such as polyimide (PI), polyethylene terephthalate (PET), propylene glycol (PPG), polycarbonate (PC), etc., or sapphire. For example, the insulating layer 110 may include an optically isotropic film. For example, the insulating layer 110 may include cyclic olefin copolymer (COC), cyclic olefin polymer (COP), optically isotropic PC, optically isotropic polymethylmethacrylate (PMMA), or the like. For example, the insulating layer 110 may be formed of a material containing an inorganic filler and an insulating resin. For example, the insulating layer 110 can be used as a thermosetting resins such as epoxy resins or a thermoplastic resin such as polyimide, as well as a resin containing reinforcing materials such as inorganic fillers such as silica and alumina, specifically, ABF (Ajinomoto Build-up Film), FR-4, BT (Bismaleimide Triazine), PID (Photo Imageable Dielectric resin), BT, etc.

The insulating layer 110 may have a thickness ranging from 5 um to 60 um. The insulating layer 110 may have a thickness ranging from 10 um to 50 um. For example, the insulating layer 110 may have a thickness ranging from 12um to 40 um.

If the thickness of the insulating layer 110 is less than 5 um, the circuit pattern included in the circuit board may not be stably protected. If the thickness of the insulating layer 110 exceeds 60um, an overall thickness of the circuit board may increase. Additionally, if the thickness of the insulating layer 110 exceeds 80um, the thickness of the circuit pattern or via increases correspondingly, and the loss of signals transmitted through the circuit pattern may increase accordingly.

At this time, the thickness of the insulating layer 110 may correspond to the distance in the thickness direction between circuit patterns arranged in different layers. For example, the thickness of the insulating layer 110 may refer to a vertical distance from a lower surface of the first circuit pattern 120 to an upper surface of the second circuit pattern 130. For example, the thickness of the insulating layer 110 may mean the thickness of the through part 140 penetrating the insulating layer 110.

A circuit pattern is disposed on a surface of the insulating layer 110.

For example, a first circuit pattern 120 may be disposed on the upper surface of the insulating layer 110. For example, a second circuit pattern 130 may be disposed on the lower surface of the insulating layer 110.

In an embodiment, a circuit board may be manufactured using an Embedded Trace Substrate (ETS) method. Accordingly, at least one of the plurality of circuit patterns included in the circuit board may have an ETS structure. Here, the ETS structure may mean that an outermost circuit pattern disposed on the outermost layer has a structure embedded in the outermost insulating layer. That is, the ETS structure means that a cavity is provided concavely toward an upper surface at a lower surface of an lowermost insulating layer disposed on an lowermost side of the circuit board, and a circuit pattern disposed at a lowermost side of the circuit board has a structure disposed in the cavity of the lowermost insulating layer. At this time, the embodiment has been described as having a structure in which the circuit pattern disposed at the lowermost side of the ETS structure is disposed in the cavity, but the present invention is not limited to this. For example, the circuit pattern disposed on the uppermost side may have a structure disposed in the cavity depending on an arrangement direction of the circuit board (e.g., the circuit board in FIG. 2 turned upside down).

For example, among the circuit patterns disposed on each layer of the circuit board, a circuit pattern disposed on at least one layer may have a structure embedded in an insulating layer. For example, in an embodiment, a second circuit pattern 130 disposed at a lower upper surface of the insulating layer may have an ETS structure. In addition, the first circuit pattern 130 disposed on the upper surface of the insulating layer 110 may have an ETS structure.

The first circuit pattern 120 may have a structure that protrudes above the upper surface of the insulating layer 110.

Additionally, the second circuit pattern 130 may have a structure embedded in the insulating layer 110.

For example, at least some regions of the second circuit pattern 130 may have a structure embedded in the insulating layer 110. For example, the entire region of the second circuit pattern 130 may have a structure embedded in the insulating layer 110.

Here, a fact that the second circuit pattern 130 has a structure embedded in the insulating layer 110 may mean that at least a portion of the side surface of the second circuit pattern 130 is covered with the insulating layer 110.

For example, a fact that the second circuit pattern 130 has an ETS structure may mean that the lower surface of the second circuit pattern 130 and the lower surface of the insulating layer 110 do not vertically overlap. Meanwhile, the upper surface of the second circuit pattern 130 may be covered by the insulating layer 110.

Meanwhile, the first circuit pattern 120 and the second circuit pattern 130 may have different layer structures.

For example, the number of layers of the first circuit pattern 120 may be different from the number of layers of the second circuit pattern 130. For example, the number of layers of the first circuit pattern 120 may be greater than the number of layers of the second circuit pattern 130.

Specifically, the second circuit pattern 130 is the circuit pattern formed first in the ETS method. Accordingly, a seed layer used to form the second circuit pattern 130 can be finally removed. Accordingly, the second circuit pattern 130 may have a one-layer structure that does not include a seed layer.

Unlike this, the first circuit pattern 120 is the circuit pattern formed last in the ETS method. Accordingly, the seed layer used to form the second circuit pattern 130 may remain on the circuit board.

For example, the first circuit pattern 120 may include a first metal layer 121 and a second metal layer 122.

The first metal layer 121 is disposed on the upper surface of the insulating layer 110. And, the second metal layer 122 is disposed on the upper surface of the first metal layer 121. The first metal layer 121 may refer to a copper foil layer (not shown) disposed on the upper surface of the insulating layer 110 when the insulating layer 110 is stacked. Alternatively, the first metal layer 121 may be a seed layer of a chemical copper plating layer formed by electroless plating on the upper surface of the insulating layer 110. Alternatively, the first metal layer 121 may include both the copper foil layer and the seed layer of the chemical copper plating layer.

The second metal layer 122 is disposed on the first metal layer 121. The second metal layer 122 may refer to an electrolytic plating layer formed by electrolytic plating using the first metal layer 121 as a seed layer.

The first circuit pattern 120 and the second circuit pattern 130 may be formed of at least one metal material selected from among gold (Au), silver (Ag), platinum (Pt), titanium (Ti), tin (Sn), copper (Cu), and zinc (Zn). In addition, the first circuit pattern 120 and the second circuit pattern 130 may be formed of paste or solder paste including at least one metal material selected from among gold (Au), silver (Ag), platinum (Pt), titanium (Ti), tin (Sn), copper (Cu), and zinc (Zn), which are excellent in bonding force. Preferably, the first circuit pattern 120 and the second circuit pattern 130 may be formed of copper (Cu) having high electrical conductivity and a relatively low cost.

The first circuit pattern 120 and the second circuit pattern 130 may have a thickness ranging from 5um to 20um. For example, the first circuit pattern 120 and the second circuit pattern 130 may have a thickness ranging from 6um to 17um. The first circuit pattern 120 and the second circuit pattern 130 may have a thickness ranging from 7 um to 16 um. If the thickness of the first circuit pattern 120 and the second circuit pattern 130 is less than 5um, the resistance of the circuit pattern increases, and signal transmission efficiency may decrease accordingly. For example, if the thickness of the first circuit pattern 120 and the second circuit pattern 130 is less than 5um, signal transmission loss may increase. For example, if the thickness of the first circuit pattern 120 and the second circuit pattern 130 exceeds 20um, the line width of the circuit patterns increases, and thus an overall volume of the circuit board may increase.

The circuit board of the embodiment includes a through part 140.

The through part 140 passes through the insulating layer 110 included in the circuit board, thereby making it possible to electrically connect circuit patterns arranged at different layers.

The through part 140 may electrically connect the first circuit pattern 120 and the second circuit pattern 130. For example, an upper surface of the through part 140 is directly connected to the lower surface of at least one of the first circuit pattern 120, and a lower surface of the through part 140 may be directly connected to the upper surface of at least one of the second circuit pattern 130.

The through part 140 may have a slope whose width gradually increases from the upper surface of the insulating layer 110 to the lower surface of the insulating layer 110.

That is, the through part 140 is manufactured by the ETS method, and is formed by filling the inside of a through hole formed as the laser process proceeds at the lower surface of the insulating layer 110. Accordingly, the through part 140 may have a trapezoidal shape where the width of the upper surface is greater than the width of the lower surface.

In this case, the through hole may be formed by any one of mechanical, laser, and chemical processing. When the via hole is formed by machining, it can be formed using methods such as milling, drilling, and routing. When the via hole is formed by laser processing, it can be formed using methods such as UV or CO₂ laser. When the via hole is formed by chemical processing, it can be formed using a chemical containing amino silane, ketones, or the like.

Meanwhile, the laser processing is a cutting method that concentrates optical energy on a surface to melt and evaporate a part of the material to take a desired shape, accordingly, complex formations by computer programs can be easily processed, and even composite materials that are difficult to cut by other methods can be processed.

In addition, the laser processing has a cutting diameter of at least 0.005mm, and has a wide range of possible thicknesses.

As the laser processing drill, it is preferable to use a YAG (Yttrium Aluminum Garnet) laser, a CO₂ laser, or an ultraviolet (UV) laser. YAG laser is a laser that can process both copper foil layers and insulating layers, and CO2 laser is a laser that can process only insulating layers.

When the through hole is formed, the through part 140 of the embodiment may be formed by filling the inside of the through hole with a conductive material. The metal material forming the through part 140 may be any one material selected from copper (Cu), silver (Ag), tin (Sn), gold (Au), nickel (Ni), and palladium (Pd). In addition, the conductive material filling may use any one or a combination of electroless plating, electrolytic plating, screen printing, sputtering, evaporation, ink-jetting and dispensing.

Meanwhile, the circuit board of the embodiment includes a first protective layer 170 and a second protective layer 180.

The first protective layer 170 may be formed on an uppermost insulating layer of the circuit board. For example, when the circuit board has a plurality of layers based on the number of insulating layers 110, the first protective layer 170 may be disposed on an upper surface of an uppermost insulating layer among the plurality of insulating layers.

The second protective layer 180 may be disposed below a lowermost insulating layer of the circuit board. For example, when the circuit board has a plurality of layers based on the number of insulating layers 110, the second protective layer 180 may be disposed on a lower surface of a lowermost insulating layer among the plurality of insulating layers.

Alternatively, when the circuit board has a single-layer structure, the first protective layer 170 may be disposed on the upper surface of the insulating layer 110, and the second protective layer 180 may be disposed under a lower surface of the insulating layer 110.

The first protective layer 170 and the second protective layer 180 may be solder resist, but are not limited thereto.

The first protective layer 170 may include a first opening 175.

The first opening 175 may vertically overlap the upper surface of the first circuit pattern 120. For example, the first circuit pattern 120 of the embodiment may include a plurality of pads. Additionally, an electrode part 160 may be disposed on at least one pad among the plurality of pads constituting the first circuit pattern 120.

Additionally, the first circuit pattern 120 may vertically overlap an upper surface of a pad on which the electrode part 160 is to be disposed among the plurality of pads of the first circuit pattern 120.

Additionally, the first opening 175 of the first protective layer 170 may vertically overlap a portion of an upper surface of the first circuit pattern 120. For example, the upper surface of the first circuit pattern 120 may include a first region vertically overlapping with the first opening 175 of the first protective layer 170 and a a second region that does not vertically overlap the first opening 175. And, the first region may refer to a central region of the upper surface of the first circuit pattern 120, and the second region may refer to an outer region of the upper surface of the first circuit pattern 120.

Accordingly, a width W1 of the first opening 175 of the first protective layer 170 may be smaller than a width of an upper surface of the first circuit pattern 120. However, the embodiment is not limited to this, the first protective layer 170 may expose an entire region of the upper surface of the first circuit pattern 120 depending on the type of the first protective layer 170.

Meanwhile, correspondingly, the second protective layer 180 disposed on the lower surface of the insulating layer 110 may include a second opening (not shown). The second opening of the second protective layer 180 may vertically overlap the lower surface of the second circuit pattern 130. For example, at least a portion of the lower surface of the second circuit pattern 130 may vertically overlap the second opening of the second protective layer 180.

Meanwhile, the circuit board of the embodiment includes an electrode part 160. The electrode part 160 may be disposed on an upper surface of a first circuit pattern that vertically overlaps the first opening 175 of the first protective layer 170 among the first circuit pattern 120 of the circuit board.

At this time, a connection part 150 may be disposed between the electrode part 160 and the upper surface of the first circuit pattern 120.

For example, the electrode part 160 may be connected to the first circuit pattern 120 using the connection part 150 as a connection layer.

The connection part 150 may be a solder layer. For example, the connection part 150 may be a solder paste. For example, the connection part 150 may contain materials of different components in a solder. For example, the solder constituting the connection part 150 may be composed of at least one of Sn-Cu, Sn-Pb, and Sn-Ag-Cu. And, a heterogeneous material constituting the connection part 150 may include any one of Al, Sb, Bi, Cu, Ni, In, Pb, Ag, Sn, Zn, Ga, Cd, and Fe. Meanwhile, the embodiment is not limited to this, and the connection part 150 may be composed of solder paste containing pure solder.

The connection part 150 may provide bonding force. For example, the connection part 150 may allow the electrode part 160 to be bonded to the upper surface of the first circuit pattern 120. The bonding may mean that the electrode part 160 is not formed by electrolytic plating on the connection part 150, but is attached to the upper surface of the first circuit pattern 120 by the bonding force provided by the connection part 150.

That is, in the embodiment, the electrode part 160 is not formed by performing an electrolytic plating process on the first circuit pattern 120, but is formed by performing a bonding process. To this end, the electrode part 160 is provided on a separate substrate (not shown) and can be bonded to the upper surface of the first circuit pattern 120 through the connection part 150.

Through this, the embodiment can remove the seed layer of the chemical copper plating layer that is essentially included between the electrode part 160 and the first circuit pattern 120. At this time, the chemical copper plating layer has a porous structure and has a problem of low adhesion with the first protective layer 170.

In contrast, the connection part 150 has excellent strength and durability compared to the chemical copper plating layer, and has excellent adhesion with the first protective layer 170.

Accordingly, in the embodiment, a final circuit board can be provided by bonding the electrode part 160 to the upper surface of the first circuit pattern 120 using the connection part 150 containing the solder paste.

Meanwhile, an upper width of the electrode part 160 may same as a lower width of the electrode part 160. That is, the electrode part 160 of the embodiment is formed on a separate substrate and has a structure that is bonded to the upper surface of the first circuit pattern 120 through the connection part 150. Accordingly, the width of the electrode part 160 can be formed without considering a width W1 of a first opening 175 of the first protective layer 170.

Accordingly, the width W2 of the upper and lower surfaces of the electrode part 160 of the embodiment may be the same, and the width W2 may be smaller than the width W 1 of the first opening 175 of the first protective layer 170.

Through this, the embodiment can allow the widths W2 of the upper and lower surfaces of the electrode part 160 to have the same width, and may allow the first protective layer 170 to have a width smaller than the width W1 of the first opening 175. Accordingly, the width of the electrode part 160 can be refined, and accordingly, the spacing between the plurality of electrode parts 160 can be reduced compared to the comparative example. Through this, the embodiment can reduce the spacing between the plurality of electrode parts 160, thereby improving circuit integration compared to the comparative example, and thereby dramatically reducing a size of the circuit board.

Meanwhile, the connection part 150 may include a plurality of portions.

The connection part 150 may include a first portion disposed between the upper surface of the first circuit pattern 120 and the lower surface of the electrode part 160.

Additionally, the connection part 150 may include a second portion disposed between a side surface of the electrode part 160 and a side wall of the first opening 175 of the first protective layer 170.

That is, the embodiment may proceed with a process of joining the electrode part 160 in a state where the connection part 150 of solder paste is applied to the upper surface of the first circuit pattern 120 vertically overlapping the first opening 175 of the first protective layer 170.

At this time, the width W2 of the electrode part 160 is smaller than the width W1 of the first opening 175 of the first protective layer 170. Accordingly, the connection part 150 may be expanded upward (for example, expanded by pressure) by the pressure applied in a process of bonding the electrode part 160. Accordingly, the connection part 150 includes a second portion between the side surface of the electrode part 160 and the side wall of the first opening 175 of the first protective layer 170 other than the first portion between the upper surface of the first circuit pattern 120 and the lower surface of the electrode part 160.

At this time, as shown in FIG. 4, an uppermost end of the connection part 150 may not be higher than the upper surface of the first protective layer 170. For example, the uppermost end of the second portion of the connection part 150 may be positioned at the same height as the upper surface of the first protective layer 170.

At this time, a fact that the uppermost end of the second portion of the connection part 150 is located higher than the upper surface of the first protective layer 170 means that at least a portion of the connection part 150 overflows out of the first opening 175 of the first protective layer 170 during a process of bonding or attaching the electrode part 160. Additionally, if at least a portion of the connection part 150 overflows outside the first opening 175 of the first protective layer 170, an electrical reliability problem may occur. For example, at least a portion of the connection part overflowing to the outside of the first opening 175 of the first protective layer 170 may be connected to a neighboring electrode part, and there is a problem that an electrical short occurs as a result.

Accordingly, the uppermost end of the connection part 150 may be portioned at the same height as the upper surface of the first protective layer 170, for example, not higher than the upper surface of the first protective layer 170.

Alternatively, as shown in FIG. 5, the uppermost end 150T of the connection part 150 may be positioned lower than the upper surface 170T of the first protective layer 170.

For example, an inner wall of the first opening 175 of the first protective layer 170 may include a first inner wall portion in contact with the connection part 150 and a second inner wall portion other than the first inner wall portion. Additionally, the second inner wall portion may not contact the connection part 150 and may not contact the electrode part 160. For example, the first opening 175 of the first protective layer 170 may include a portion 170V that is not filled with the connection part 150 and the electrode part 160. For example, the portion 170V of the first opening 175 may be described as an air gap until the first molding layer 190 described below is formed.

That is, the first opening 175 of the first protective layer 170 in the embodiment is not completely filled through the connection part 150 and the electrode part 160. For example, the connection part 150 and the electrode part 160 may be formed to fill a region excluding the portion 170V of the first opening 175 of the first protective layer 170.

Through this, the embodiment can further prevent the problem of the connection part 150 overflowing to the outside of the first opening 175 of the first protective layer 170, and this can solve electrical reliability problems such as circuit shorts. In addition, the embodiment allows designing the width of the electrode part 160 considering the portion 170V. Accordingly, the width of the electrode part 160 can be further reduced, and thus the spacing between a plurality of neighboring electrode parts can be reduced.

Through this, the electrode part 160 of the embodiment may not vertically overlap the first protective layer 170. For example, the electrode part 160 has a structure that is selectively disposed only within the first opening 175 of the first protective layer 170. Accordingly, the electrode part 160 does not vertically overlap the first protective layer 170, but may vertically overlap the first opening 175 of the first protective layer 170.

Likewise, the connection part 150 may not vertically overlap the first protective layer 170. For example, the connection part 150 may have a structure that is selectively disposed only within the first opening 175 of the first protective layer 170. Accordingly, the connection part 150 may not vertically overlap the first protective layer 170, but may vertically overlap the first opening 175 of the first protective layer 170.

Meanwhile, the circuit board of the embodiment includes a first molding layer 190.

The first molding layer 190 may be disposed on the upper surface of the first protective layer 170.

The first molding layer 190 is disposed on the first protective layer 170 and may thus cover the side surface of the electrode part 160.

For example, the first molding layer 190 may mold the electrode part 160.

The electrode part 160 may be covered through the first molding layer 190.

At this time, the electrode part 160 may pass through the first molding layer 190. For example, the upper surface of the electrode part 160 may not be lower than the upper surface of the first molding layer 190. For example, the upper surface of the electrode part 160 may be positioned on the same plane as the upper surface of the first molding layer 190. For example, the upper surface of the electrode part 160 may be positioned higher than the upper surface of the first molding layer 190.

The first molding layer 190 may be EMC (Epoxy Molding Compound), but is not limited thereto.

Meanwhile, in a structure of FIG. 4, the first molding layer 190 may have a structure that contacts the upper surface of the first protective layer 170 and the uppermost end of the connection part 150 while having a structure surrounding the side surface of the electrode part 160.

Additionally, in a structure of FIG. 5, the first molding layer 190 may be formed to fill the portion 170V of the first protective layer 170 while having a structure surrounding the side surface of the electrode part 160. Accordingly, a lowermost end of the first molding layer 190 may be positioned higher than the upper surface of the first protective layer 170.

A circuit board according to an embodiment includes an electrode part. The electrode part may function as a mounting portion on which a chip is mounted, or an attachment portion to which an external substrate is attached. For example, the electrode part may also be referred to as a post bump. At this time, the electrode part may be disposed at a certain height on the first circuit pattern. Also, a first connection part is disposed between an electrode part and a first circuit pattern. At this time, the first connection part is a bonding layer for bonding the electrode part to the first circuit pattern. Specifically, in a circuit board in a comparative example, a seed layer of the electrode part is disposed between the first circuit pattern and the electrode part. In contrast, the embodiment has a structure in which a seed layer of the electrode part is not disposed between the first circuit patterns of the electrode part. For example, the embodiment has a structure in which the electrode part and the first circuit pattern are interconnected through a first connection part such as solder paste. Accordingly, the embodiment can improve the physical and electrical reliability of the circuit board by replacing the seed layer, which is the chemical copper plating layer of the comparative example, with the first connection part. For example, the embodiment allows the electrode part to be formed using a connection part with a higher metal density compared to a chemical copper plating layer, and accordingly, it is possible to prevent the connection part from being damaged by external shock, and thereby improve physical reliability. For example, the embodiment allows the electrode part to be formed using a connection part that has high adhesion to the protective layer compared to the chemical copper plating layer, and accordingly, it is possible to solve the problem of the connection part and the electrode part being separated from the circuit board, thereby improving physical or electrical reliability. For example, the embodiment may allow a de-smear process required in a process of forming an electrode part using the chemical copper plating layer in the comparative example to be omitted, and accordingly, it can solve problems such as surface contamination of the protective layer that may occur in the de-smear process.

Meanwhile, the electrode part of the embodiment is formed from a separate electrode substrate and is bonded to the first circuit board with the connection part as a bonding layer, and accordingly, there are no restrictions in forming a width of the electrode part. For example, the comparative example had to consider a width of a dry film exposure and development depending on a width of an opening of the protective layer to form the electrode part, and accordingly, the width of the upper surface of the electrode part was formed to be greater than the width of the lower surface. In contrast, the embodiment does not have the same restrictions as in the comparative example above, and accordingly, the width of the upper and lower surfaces of the electrode part can be made the same. Furthermore, in an embodiment, the width of the upper and lower surfaces of the electrode part may be smaller than the width of the opening of the protective layer. Accordingly, the embodiment can reduce a separation distance between a plurality of electrode parts. Through this, the embodiment can improve the circuit integration of the circuit board and further reduce a size of the circuit board in a horizontal direction or a vertical direction.

Meanwhile, hereinafter, a package substrate according to an embodiment will be described.

The package substrate of the embodiment may be divided into various types depending on the circuit board and a type of a chip mounted on the circuit board. For example, the package substrate includes the circuit board shown in FIG. 3 and may include at least one chip mounted on the circuit board.

For example, a circuit board as shown in FIG. 3 provides a mounting space where at least one chip can be mounted. The number of chips mounted on the circuit board of the embodiment may be one, alternatively, there may be two, and alternatively, there may be three or more. For example, one processor chip may be mounted on the circuit board, and alternatively, at least two processor chips performing different functions may be mounted on the circuit board. Alternatively, one memory chip may be mounted along with one processor chip. Alternatively, at least two processor chips and at least one memory chip performing different functions may be mounted.

However, the embodiment is not limited to this, and the chip disposed on the circuit board may include at least one active device and/or at least one passive device. For example, a chip disposed on a circuit board of an embodiment may be an electronic component, which may be divided into active devices and passive devices. In addition, the active device is a device that actively uses a nonlinear portion, and the passive device refers to a device that does not use nonlinear characteristics even though both linear and nonlinear characteristics exist. For example, the active device may include transistors, IC semiconductor chips, etc. and the passive device may include condensers, resistors, and inductors. The passive device can increase the signal processing speed of the semiconductor chip, which is an active device, or perform a filtering function.

As an example, the chip disposed on the circuit board of the embodiment may be any one of a driver IC chip, a diode chip, a power IC chip, a touch sensor IC chip, an MLCC chip, a BGA chip, and a chip capacitor.

That is, a first package substrate 200 as shown in FIG. 6 may have a chip mounted only on an upper portion of the circuit board.

For example, the first package substrate 200 may be a mounting substrate on which a first semiconductor device 220 is mounted.

At this time, the first package substrate 200 may include a first molding layer 190. Additionally, the first molding layer 190 may include a cavity. The cavity of the first molding layer 190 may vertically overlap a region in which a semiconductor device is to be mounted among the upper regions of the first protective layer 170.

For example, the cavity of the first molding layer 190 may vertically overlap a mounting pad on which the first semiconductor device 220 of the first circuit pattern 120 included in the circuit board is to be mounted.

Additionally, the first package substrate 200 may include a second connection part 210 disposed on the upper surface of the first circuit pattern that vertically overlaps the cavity of the first molding layer 190. The second connection part 210 may have a hexahedral shape. For example, a cross section of the second connection part 210 may have a square shape. For example, the second connection part 210 may have a spherical shape. For example, a cross section of the second connection part 210 may include a circular shape or a semicircular shape. For example, a cross section of the second connection part 210 may include a partially or entirely rounded shape. A cross-sectional shape of the second connection part 210 may be flat on one side and curved on the other side. The second connection part 210 may be a solder ball, but is not limited thereto.

The embodiment may include a first semiconductor device 220 disposed on the second connection part 210. The first chip 220 may be a processor chip, but is not limited thereto. For example, the first chip 220 may be an application processor (AP) chip selected from a central processor (e.g., CPU), graphics processor (e.g., GPU), digital signal processor, cryptographic processor, microprocessor, or microcontroller.. However, the embodiment is not limited to this, and the first chip 220 may be a memory chip as described above, alternatively, it may be an active device that is an electronic component, or alternatively, it may be a passive device. Meanwhile, in FIG. 6, only one chip is shown mounted on an upper portion of the circuit board, but the embodiment is not limited to this. For example, at least two or more chips may be mounted on the circuit board.

Meanwhile, a terminal 225 of the first semiconductor device 220 may be connected to the first circuit pattern vertically overlapping the cavity through the second connection part 210.

Meanwhile, when two semiconductor devices are mounted on the circuit board, the two semiconductor devices may be spaced apart from each other in a width or a length direction.

For example, the first semiconductor device 220 may include a first-first semiconductor device and a first-second semiconductor device that are spaced apart from each other. Additionally, the first-first semiconductor device and the first-second semiconductor device may be spaced apart from each other in the horizontal direction. At this time, a spacing between the first-first semiconductor device and the first-second semiconductor device may be 150 µm or less. For example, the spacing between the first-first semiconductor device and the first-second semiconductor device may be 120 µm or less. For example, the spacing between the first-first semiconductor device and the first-second semiconductor device may be 100 µm or less.

Preferably, the spacing between the first-first semiconductor device and the first-second semiconductor device may range from 60 um to 150 um. Preferably, the spacing between the first-first semiconductor device and the first-second semiconductor device may range from 70 um to 120 um. Preferably, the spacing between the first-first semiconductor device and the first-second semiconductor device may range from 80 um to 110 um. If the spacing between the first-first semiconductor device and the first-second semiconductor device is less than 60um, mutual interference occurs between the two semiconductor devices, and as a result, problems may occur in the operation of the first-first semiconductor device or the first-second semiconductor device.

In addition, if the spacing between the first-first semiconductor device and the first-second semiconductor device is greater than 150um, signal transmission loss may increase as the distance between the first-first semiconductor device and the first-second semiconductor device increases. If the spacing between the first-first semiconductor device and the first-second semiconductor device is greater than 150um, a volume of the first package substrate 200 may increase.

Meanwhile, a second molding layer 230 may be disposed in the cavity of the first molding layer 190 in the embodiment.

The second molding layer 230 may fill the cavity of the first molding layer 190 and protect the first semiconductor device 220 mounted within the cavity.

At this time, the first molding layer 190 and the second molding layer 230 may be formed of different materials. For example, the first molding layer 190 may function to stably support the electrode part 160. For example, the second molding layer 230 can function to stably protect the first semiconductor device 220 while dissipating heat generated from the first semiconductor device 220 disposed in the cavity to an outside.

For example, the second molding layer 230 may have a low dielectric constant to stably protect the first semiconductor device 220 while increasing the heat dissipation characteristics of the first semiconductor device 220. For example, a dielectric constant (Dk) of the second molding layer 230 may be 0.2 to 10. For example, the dielectric constant (Dk) of the second molding layer 230 may be 0.5 to 8. For example, the dielectric constant (Dk) of the second molding layer 230 may be 0.8 to 5. Accordingly, the embodiment allows the second molding layer 230 to have a low dielectric constant, thereby improving heat dissipation characteristics for heat generated from the first chip 220.

Additionally, in an embodiment, the first molding layer 190 and the second molding layer 230 may include different materials. The first molding layer 190 is used to protect the electrode part 160, and the second molding layer 230 is used to protect the first chip 220.

Accordingly, the first molding layer 190 and the second molding layer 230 may have different strengths. As described above, in the embodiment, the first molding layer 190 and the second molding layer 230 may be made of different materials, thereby stably protecting the electrode part 160 and the first chip 220.

In addition, the embodiment uses the first molding layer 190 to prevent damage to the electrode part 160 during a semiconductor device mounting process that is performed while the electrode part 160 is formed, and this can improve product reliability.

Meanwhile, the first package substrate 200 of the embodiment may include a third connection part 240. The third connection part 240 may vertically overlap the second opening of the second protective layer 180 of the circuit board.

For example, the third connection part 240 may be disposed on the lower surface of the second circuit pattern 130 that vertically overlaps the second opening of the second protective layer 180.

The third connection part 240 may be formed for bonding purposes to bond an external substrate to a lower part of the package substrate. For example, the third connection part 240 may be a bonding layer for connecting the package substrate 200 and a main board of an external device.

Meanwhile, referring to FIG. 7, the package substrate 300 according to the second embodiment may have semiconductor devices mounted on both upper and lower portions of the circuit board.

For example, in FIG 6, the first semiconductor device is mounted only on the upper portion of the circuit board, but in FIG. 7, the first semiconductor device is mounted on the upper portion of the circuit board, and the second semiconductor device is mounted on the lower portion of the circuit board.

To this end, in the package substrate shown in FIG. 6, the structure excluding the third connection part 240 may be substantially the same as the package substrate in FIG. 7. Accordingly, only the portions that are different from the package substrate of FIG. 6 will be described.

A package substrate 300 may include a second semiconductor device 340 mounted on the lower portion of the circuit board.

At this time, the second semiconductor device 340 may be mounted directly through a connection part disposed on the circuit pattern, corresponding to the first semiconductor device 220, alternatively, it can be mounted through a separate connecting part 320 as shown in FIG. 7.

At this time, the connecting part 320 may be an electrolytic plating layer formed by performing electrolytic plating on the lower surface of the second circuit pattern 130. To this end, a seed layer 310 of the connecting part 320 may be formed between the connecting part 320 and the second circuit pattern 130.

At this time, the seed layer 310 is also a seed layer of the connecting part 320 and a seed layer of the second circuit pattern 130.

Specifically, the circuit board of the example is manufactured through the ETS method. At this time, the seed layer 310 is a seed layer used when forming the second circuit pattern 130 in the ETS method. At this time, in the embodiment, the connecting part 320 may be formed using the seed layer of the second circuit pattern 130.

Meanwhile, a fourth connection part 330 may be disposed on the lower surface of the connecting part 320. The fourth connection part 330 may be a solder ball, but is not limited thereto.

The second semiconductor device 340 may be mounted below the connecting part 320 through the fourth connection part 330. For example, a terminal 345 of the second semiconductor device 340 may be electrically connected to the connecting part 320 through the fourth connection part 330.

Meanwhile, the package substrate of the embodiment may include a third molding layer 350 disposed on the lower surface of the second protective layer 180 and covering the second chip 340 and the connecting part 320. At this time, the third molding layer 350 may include the same material as the second molding layer 230, but is not limited thereto.

Meanwhile, as shown in FIG. 8, the package substrate 400 of the embodiment may further include an upper substrate 420.

At this time, the package substrate 400 of the third embodiment may have a structure in which the upper substrate 420 is attached to the package substrate 200 of the first embodiment, or alternatively, the upper substrate 420 may be attached to the package substrate 300 of the second embodiment.

In the drawings, a structure in which the upper substrate 420 is disposed on the package substrate 300 according to the second embodiment will be described , for convenience of explanation.

A fifth connection part 410 may be disposed on the electrode part 160 of the circuit board.

At this time, a plurality of electrode parts are formed on the circuit board and spaced apart from each other at a predetermined distance, and the fifth connection part 410 may be formed on each of the plurality of electrode parts spaced apart from each other.

Additionally, the upper substrate 420 may be attached to the electrode part 160 through the fifth connection part 410.

The upper substrate 420 may be a memory substrate on which a memory chip is mounted, but is not limited thereto. For example, the upper substrate 420 may be the main board of an external device connected to the package substrate.

### -Manufacturing method-

Hereinafter, a method of manufacturing the circuit board shown in FIG. 3 according to an embodiment will be described in order of processes.

FIGS. 9 to 22 are views for explaining a method of manufacturing the circuit board shown in FIG. 3 in order of processes.

Referring to FIG. 9, in the embodiment, a carrier board that is the basis for manufacturing a circuit board is prepared. For example, the circuit board of the embodiment is manufactured by the ETS method, and accordingly, a carrier board, which is a basic material for manufacturing the circuit board by the ETS method, is prepared.

For example, the embodiment may prepare a carrier board having a carrier insulating layer CB1 and a carrier metal layer CB2 disposed on at least one surface of the carrier insulating layer CB1.

At this time, the carrier metal layer CB2 may be disposed on only one of the upper and lower surfaces of the carrier insulating layer CB1, or alternatively, may be disposed on both surfaces. For example, the carrier metal layer CB2 is disposed only on one side of the carrier insulating layer CB1, and accordingly, the ETS process for manufacturing a circuit board can be performed only on one side of the carrier insulating layer CB1. Alternatively, the carrier metal layer CB2 can be disposed on both sides of the carrier insulating layer CB1, and accordingly, the ETS process for manufacturing a circuit board can be performed simultaneously on both sides of the carrier board. At this time, when the ETS process is performed simultaneously on both sides of the carrier board, two circuit boards can be manufactured simultaneously.

The carrier metal layer CB2 may be an electroless plating layer formed by electroless plating on the carrier insulating layer CB1, but is not limited thereto. For example, the carrier insulating layer CB1 and the carrier metal layer CB2 may be Copper Clad Laminate CCL.

Meanwhile, the carrier metal layer CB2 may be composed of multiple layers. For example, if the carrier board is made of CCL, electroless plating or sputtering may be performed on the copper foil layer of the CCL to additionally form a plating layer. In addition, the plating layer can enable the carrier board to be easily separated from the circuit board after the circuit board manufacturing process is completed.

Meanwhile, a plurality of circuit boards can be manufactured simultaneously on both sides of the prepared carrier board. However, hereinafter, it will be explained that manufacturing of the circuit board is carried out only on one side of the carrier board for convenience of explanation.

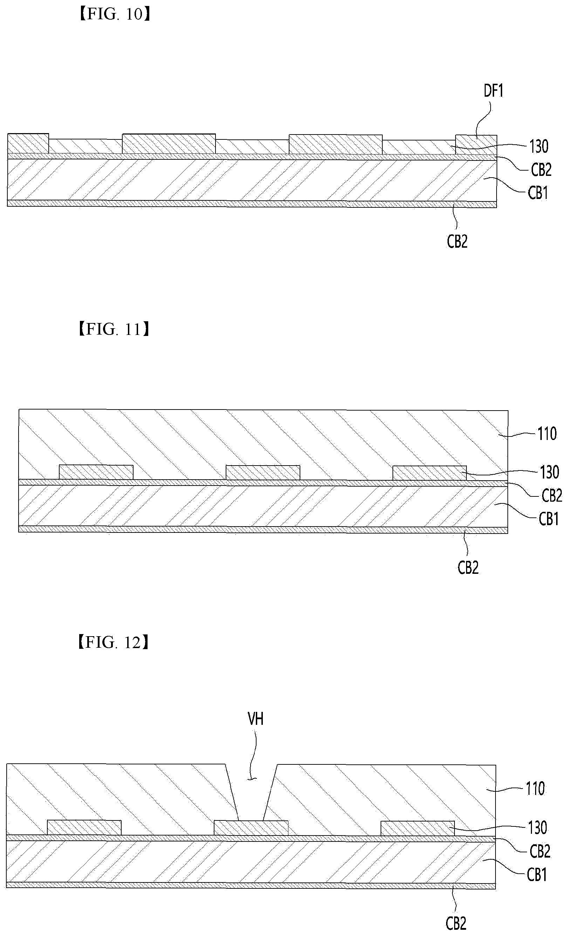

Next, as shown in FIG. 10, in the embodiment, a first dry film DF1 is formed on the upper surface of the carrier metal layer CB2. At this time, the first dry film DF1 may include an open region.

For example, the first dry film DF1 may include an open region formed on a upper surface of the carrier metal layer CB2 that vertically overlaps a region where the second circuit pattern 130 will be formed.

When the first dry film DF1 is formed, the embodiment may proceed with a process of forming a second circuit pattern 130 that fills the open region of the first dry film DF1 by performing electrolytic plating using the carrier metal layer CB2 as a seed layer.

Meanwhile, when the electrolytic plating process for forming the second circuit pattern 130 is completed, a process of removing the first dry film DF 1 may be performed.

Next, as shown in FIG. 11, the embodiment may proceed with a process of stacking the insulating layer 110 on the carrier metal layer CB2 and the second circuit pattern 130.

At this time, although the stacked layer is shown in the drawing as including only the insulating layer 110, but the embodiment is not limited thereto. For example, a copper foil layer (not shown) may be disposed on the upper surface of the insulating layer 110 to maintain the flatness of the laminated insulating layer 110.

Next, as shown in FIG. 12, the embodiment may proceed with a process of forming a through hole VH penetrating the insulating layer 110. For example, in an embodiment, a laser processing process may be performed on the insulating layer 110 to form a through hole VH penetrating the insulating layer 110. The through hole VH may have an inclination whose width gradually decreases toward the lower surface of the insulating layer 110.

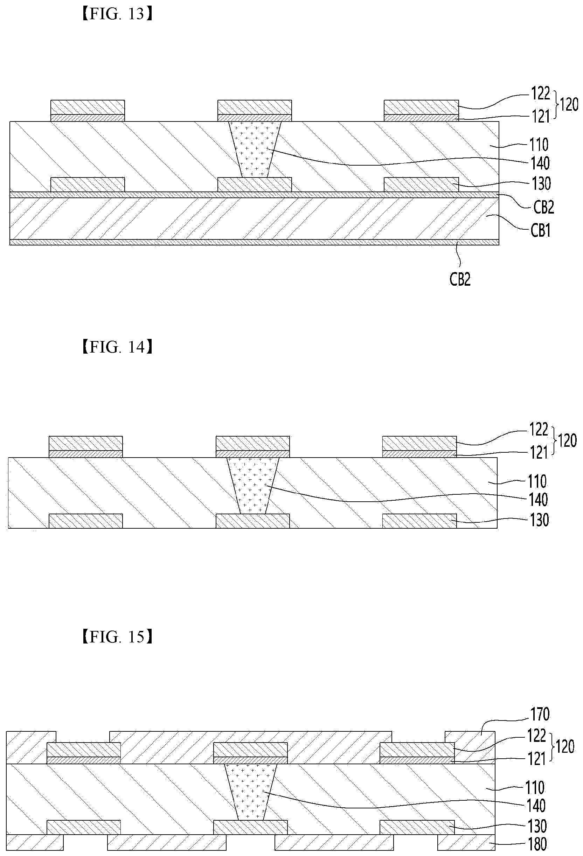

Next, as shown in FIG. 13, the embodiment may proceed with a process of forming a through part 140 that fills the through hole (VH) and a first circuit pattern 120 disposed on the upper surface of the insulating layer 110.

To this end, the embodiment may proceed with a process of forming the first metal layer 121 on the upper surface of the insulating layer 110 and the inner wall of the through hole VH. At this time, although the first metal layer 121 is shown in the drawing as being formed only on a portion of the upper surface of the insulating layer 110, the first metal layer 121 will actually be formed on the inner wall of the through hole VH.

Thereafter, in the embodiment, when the first metal layer 121 is formed, the embodiment may proceed with a process of forming a through part 140 that fills the through hole VH and a first circuit pattern 120 that protrudes above the upper surface of the insulating layer 110 by performing electrolytic plating using the first metal layer 121 as a seed layer.

Next, as shown in FIG. 14, the embodiment may proceed with a process of removing the carrier board.

To this end, the embodiment may proceed with a process of separating and removing the carrier insulating layer CB1 from the carrier board, and then etching and removing the carrier metal layer CB2 accordingly.

Next, the embodiment may proceed with a process of forming the first protective layer 170 and the second protective layer 180, as shown in FIG. 15.

To this end, the embodiment may form a first protective layer 170 on the upper surface of the insulating layer 110 and the upper surface of the first circuit pattern 120. And, in an embodiment, when the first protective layer 170 is formed, a first opening may be formed in a region of the upper surface of the first circuit pattern 120 that vertically overlaps a region where the electrode part 160 will be disposed. For example, the first opening of the first protective layer 170 may vertically overlap the upper surface of the first circuit pattern 120 on which the electrode part 160 is to be disposed.

Additionally, in the embodiment, a second protective layer 180 may be formed on the lower surface of the insulating layer 110 and the lower surface of the second circuit pattern 130. And, the embodiment may form a second opening in the second protective layer 180. The second opening may vertically overlap at least a portion of the lower surface of the second circuit pattern 130.

Meanwhile, when the manufacturing of the circuit board is completed through the above process, the embodiment may proceed with a process for manufacturing an electrode substrate including the electrode part 160.

For this purpose, the embodiment may prepare a substrate layer that is the basis for manufacturing an electrode substrate.

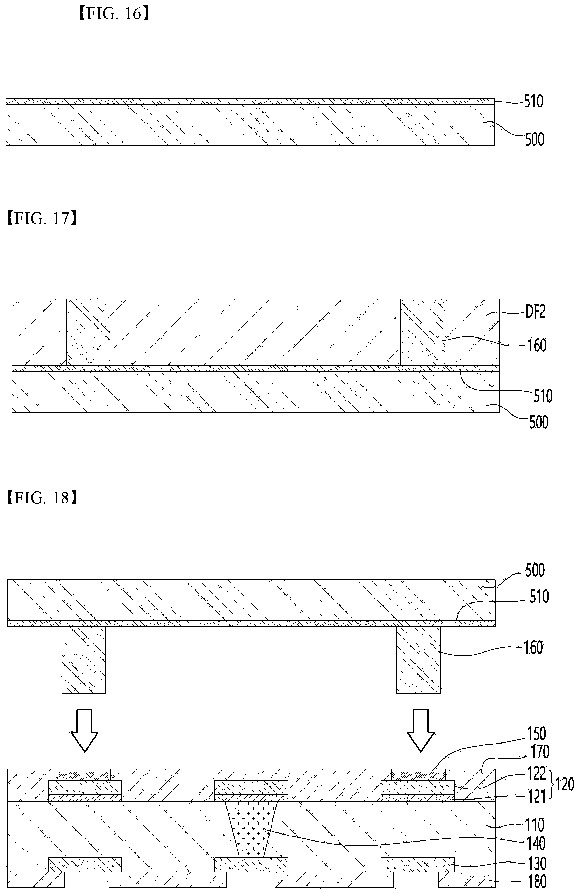

Specifically, as shown in FIG. 16, the embodiment may prepare a material including a second insulating layer 500 and a copper foil layer 510 disposed on the second insulating layer 500. A laminated structure of the second insulating layer 500 and the copper foil layer 510 may be CCL, but is not limited thereto. For example, the copper foil layer 510 may be an electroless plating layer formed by performing electroless plating on the second insulating layer 500.

Next, as shown in FIG. 17, the embodiment may form a second dry film DF2 on the copper foil layer 510. At this time, the second dry film DF2 may include an open region. For example, the second dry film DF2 may include an open region that vertically overlaps a region on the upper surface of the copper foil layer 510 where the electrode part 160 will be formed.

Next, when an open region is formed in the second dry film DF2, the embodiment may proceed with a process of electrolytic plating using the copper foil layer 510 as a seed layer to form an electrode part 160 that fills the open region of the second dry film DF2.

Next, the embodiment may proceed with a process of forming a first connection part 150 on the manufactured circuit board, as shown in FIG. 18. For example, the first connection part 150 may be disposed on the upper surface of the first circuit pattern 120 that vertically overlaps the first opening of the first protective layer 170.

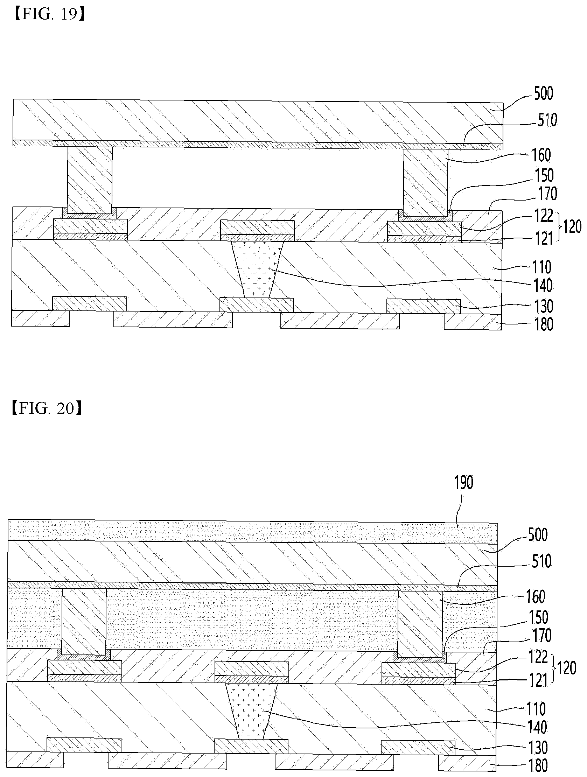

Next, in the embodiment, as shown in FIG. 19, a process of bonding the electrode part 160 onto the first connection part 150 may be performed by pressing the electrode part 160 and the first connection part 150 in a state of vertically aligning the electrode substrate on which the electrode part 160 is formed in an inverted state.

At this time, the first connection part 150 has a thin film shape before the electrode part 160 is bonded, but may be expanded by the pressure after the electrode part 160 is bonded. For example, the first connection part 150 may include a first portion in contact with the lower surface of the electrode part 160 and a second portion in contact with the side surface of the electrode part 160 by pressurizing the electrode part 160.

Next, in the embodiment, as shown in FIG. 20, when the bonding of the electrode part 160 is completed, the embodiment may proceed with a process of forming a first molding layer 190 for molding the electrode substrate including the electrode part 160 on the circuit board.

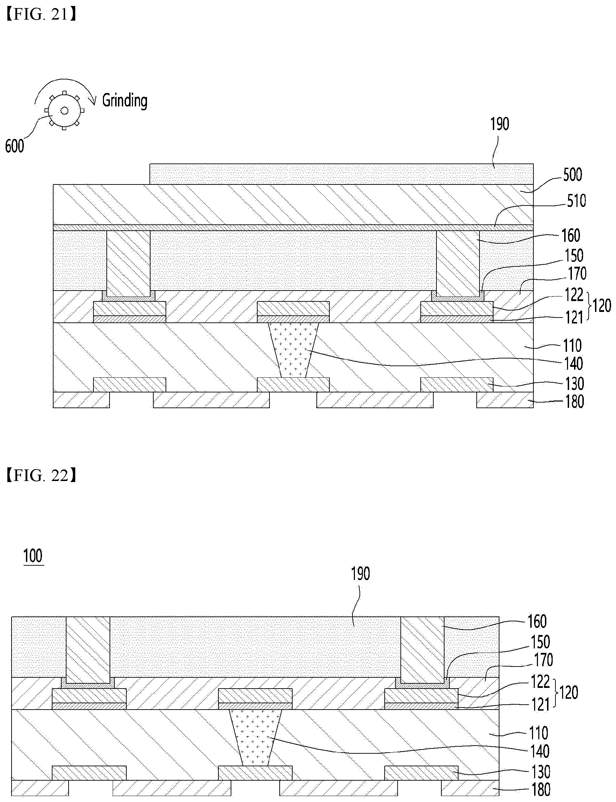

Next, as shown in FIG. 21, the embodiment may proceed with a process of removing a portion of the first molding layer 190, the second insulating layer 500 of the electrode substrate, and the copper foil layer 510 by grinding. For example, in the embodiment, a grinding process may be performed using a grinder 600 to expose the upper surface of the electrode part 160. Through this, as shown in FIG. 22, the upper surface of the electrode part 160 can be positioned on the same plane as the upper surface of the first molding layer 190. For example, the electrode part 160 may penetrate the first molding layer 190.

A circuit board according to an embodiment includes an electrode part. The electrode part may function as a mounting portion on which a chip is mounted, or an attachment portion to which an external substrate is attached. For example, the electrode part may also be referred to as a post bump. At this time, the electrode part may be disposed at a certain height on the first circuit pattern. Also, a first connection part is disposed between an electrode part and a first circuit pattern. At this time, the first connection part is a bonding layer for bonding the electrode part to the first circuit pattern. Specifically, in a circuit board in a comparative example, a seed layer of the electrode part is disposed between the first circuit pattern and the electrode part. In contrast, the embodiment has a structure in which a seed layer of the electrode part is not disposed between the first circuit patterns of the electrode part. For example, the embodiment has a structure in which the electrode part and the first circuit pattern are interconnected through a first connection part such as solder paste. Accordingly, the embodiment can improve the physical and electrical reliability of the circuit board by replacing the seed layer, which is the chemical copper plating layer of the comparative example, with the first connection part. For example, the embodiment allows the electrode part to be formed using a connection part with a higher metal density compared to a chemical copper plating layer, and accordingly, it is possible to prevent the connection part from being damaged by external shock, and thereby improve physical reliability. For example, the embodiment allows the electrode part to be formed using a connection part that has high adhesion to the protective layer compared to the chemical copper plating layer, and accordingly, it is possible to solve the problem of the connection part and the electrode part being separated from the circuit board, thereby improving physical or electrical reliability. For example, the embodiment may allow a de-smear process required in a process of forming an electrode part using the chemical copper plating layer in the comparative example to be omitted, and accordingly, it can solve problems such as surface contamination of the protective layer that may occur in the de-smear process.

Meanwhile, the electrode part of the embodiment is formed from a separate electrode substrate and is bonded to the first circuit board with the connection part as a bonding layer, and accordingly, there are no restrictions in forming a width of the electrode part. For example, the comparative example had to consider a width of a dry film exposure and development depending on a width of an opening of the protective layer to form the electrode part, and accordingly, the width of the upper surface of the electrode part was formed to be greater than the width of the lower surface. In contrast, the embodiment does not have the same restrictions as in the comparative example above, and accordingly, the width of the upper and lower surfaces of the electrode part can be made the same. Furthermore, in an embodiment, the width of the upper and lower surfaces of the electrode part may be smaller than the width of the opening of the protective layer. Accordingly, the embodiment can reduce a separation distance between a plurality of electrode parts. Through this, the embodiment can improve the circuit integration of the circuit board and further reduce a size of the circuit board in a horizontal direction or a vertical direction.

The characteristics, structures and effects described in the embodiments above are included in at least one embodiment but are not limited to one embodiment. Furthermore, the characteristics, structures, and effects and the like illustrated in each of the embodiments may be combined or modified even with respect to other embodiments by those of ordinary skill in the art to which the embodiments pertain. Thus, it should be construed that contents related to such a combination and such a modification are included in the scope of the embodiment.

The above description has been focused on the embodiment, but it is merely illustrative and does not limit the embodiment. A person skilled in the art to which the embodiment pertains may appreciate that various modifications and applications not illustrated above are possible without departing from the essential features of the embodiment. For example, each component particularly represented in the embodiment may be modified and implemented. In addition, it should be construed that differences related to such changes and applications are included in the scope of the embodiment defined in the appended claims.

## Claims

1. A circuit board comprising:
an insulating layer;
a first circuit pattern disposed on the insulating layer;
a first protective layer disposed on the insulating layer and including an opening that vertically overlaps an upper surface of the first circuit pattern;
a first connection part disposed in the opening; and
an electrode part disposed on the first connection part,
wherein a width of an upper surface of the electrode part is smaller than a width of the opening of the first protective layer.

2. The circuit board of claim 1, wherein the first connection part includes a solder.

3. The circuit board of claim 1, wherein the electrode part does not overlap vertically with the first protective layer.

4. The circuit board of claim 1, wherein the first connection part does not overlap vertically with the first protective layer.

5. The circuit board of any one of claims 1 to 4, wherein the width of the upper surface of the electrode part is same as a width of a lower surface of the electrode part.

6. The circuit board of any one of claims 1 to 4, further comprising:
a through part passing through the insulating layer.

7. The circuit board of any one of claims 1 to 4, wherein the first connection part includes:
a first portion disposed between an upper surface of the first circuit pattern and a lower surface of the electrode part, and
a second portion extending upward from the first portion and disposed between a side surface of the electrode part and an inner wall of the opening of the first protective layer.

8. The circuit board of claim 7, wherein the second portion of the first connection part does not contact an upper surface of the first protective layer.

9. The circuit board of claim 7, wherein an uppermost end of the second portion of the first connection part is positioned on a same plane as the upper surface of the first protective layer.

10. The circuit board of claim 7, wherein an uppermost end of the second portion of the first connection part is positioned lower than the upper surface of the first protective layer.
